Europäisches Patentamt

European Patent Office

Office européen des brevets

(11) Numéro de publication: **0 273 791 B1**

## FASCICULE DE BREVET EUROPEEN

(45) Date de publication de fascicule du brevet:
17.07.91

(21) Numéro de dépôt: 87402667.7

(22) Date de dépôt: 25.11.87

(51) Int. Cl.⁵: **F24F 3/16**

(54) Installation de stockage et de transfert d'objets dans une atmosphère de haute propreté.

(30) Priorité: 28.11.86 FR 8616653
04.09.87 FR 8712292

(43) Date de publication de la demande:
06.07.88 Bulletin 88/27

(45) Mention de la délivrance du brevet:
17.07.91 Bulletin 91/29

(84) Etats contractants désignés:
BE DE GB IT NL

(56) Documents cités:
EP-A- 0 195 703

BRITISH KINEMATOGRAPHY SOUND AND TE-
LEVISION SOCIETY JOURNAL, vol. 53, no. 4,
avril 1971, pages 122-126,131, Londres, GB;
R.N. HAIG: "Environmental and contamination control"

(73) Titulaire: COMMISSARIAT A L'ENERGIE ATO-
MIQUE Etablissement de Caractère Scientifique Technique et Industriel
31/33, rue de la Fédération
F-75015 Paris(FR)

(72) Inventeur: Lazzari, Jean-Pierre
45, Chemin de Malanot
F-38700 Corenc(FR)
Inventeur: Cortial, Henri
4, Rivoire de la Dame
F-38360 Sassenage(FR)

(74) Mandataire: Mongrédien, André et al
c/o BREVATOME 25, rue de Ponthieu
F-75008 Paris(FR)

Rank Xerox (UK) Business Services

## Description

La présente invention se rapporte au domaine de la ventilation de locaux à l'intérieur desquels l'air doit être d'une très grande propreté et s'applique plus particulièrement dans l'industrie de la microélectronique.

On rappelle que, dans des industries comme la microélectronique, certaines opérations telles que la préparation de plaquettes de silicium doivent être effectuées dans une atmosphère pratiquement exempte d'impuretés ou de poussières, c'est-à-dire dans des locaux appelés "salles blanches". Ceci est obtenu en ventilant les locaux par de l'air qui a été filtré par des filtres absolus, c'est-à-dire des filtres qui arrêtent pratiquement toutes les poussières, mêmes les plus fines. Il existe à l'heure actuelle quatre méthodes principales pour maintenir la pureté de l'air dans les salles blanches de la microélectronique.

Dans le premier type de salle blanche, l'air est introduit dans le local par le plafond et l'écoulement au plafond est un écoulement laminaire. Le personnel se trouve dans la salle, ainsi que les différents équipements. Cependant, on cherche à réduire le volume occupé par ces derniers dans la salle blanche. Pour cela, on dispose les différentes machines ou appareils à travers une cloison étanche, de sorte qu'une partie de ceux-ci se trouve dans la salle blanche et le reste dans un local dont le degré de propreté n'est pas aussi élevé. Cette solution présente pour principal inconvénient la nécessité d'avoir un volume d'air propre très important et le volume des locaux de traitement d'air est souvent trois à quatre fois plus important que le volume de la salle blanche elle-même. Les coûts d'installation et de fonctionnement sont donc très élevés et la lourdeur de la structure ne permet pas de changement d'équipement. Enfin, ce type de salle blanche présente des inconvénients pour le personnel qui subit des contraintes vestimentaires très lourdes.

C'est pourquoi on a utilisé un autre type de structure de salle blanche dans lequel le personnel, générateur de particules et donc de poussières, est remplacé par des robots. Si la diminution du personnel présent dans la salle permet d'obtenir une meilleure propreté, il n'en reste pas moins que les robots sont eux-mêmes générateurs de poussières : bien qu'ils en produisent moins que des êtres humains, on atteint des niveaux qui ne sont pas négligeables. D'autre part, la réduction du personnel est faible, car la seule fonction de manutention des plaquettes de silicium n'occupe les employés que pour une durée inférieure à 10 % de leur temps total de travail. C'est pourquoi cette solution, qui nécessite des modifications importantes dans les salles et les équipements, n'est pas réellement rentable.

Une troisième solution consiste à raccorder les différents équipements à l'aide d'un tube dans lequel les plaquettes de silicium circulent au moyen d'un chariot automatique. Une ambiance ultrapropre est maintenue à l'intérieur de ce tube et non pas dans la salle. Ainsi, le personnel se trouve dans un environnement dont le degré de propreté est plus faible, mais qui est moins contraignant, et les coûts d'installation et de fonctionnement de la ventilation sont diminués. Toutefois, cette solution présente encore des inconvénients. Tout d'abord, une fois que le tube est installé, il n'accepte que difficilement des modifications. D'autre part, son raccordement aux différents équipements ou aux différentes machines alourdit les opérations de modification ou de changement de ces machines. Enfin, les chariots qui circulent à l'intérieur des tubes sont complexes, générateurs de poussières et d'une maintenance difficile.

C'est pourquoi on a adopté un autre système dans lequel les plaquettes de silicium sont enfermées dans une boîte étanche pour leur transfert à l'intérieur du local de traitement. L'atmosphère à l'intérieur de ces boîtes étanches est de très haute propreté alors que le local est d'une propreté moyenne. Le transfert d'une boîte à l'autre ou d'une boîte à une machine s'opère grâce à un système de tiroirs qui évite l'introduction de particules extérieures ou de poussières dans les conteneurs étanches. Si cette solution présente l'avantage que les équipements de ventilation sont relativement simples du fait que la propreté de la salle est moyenne et que l'utilisation de boîtes étanches n'entraîne pas toutes les complications dues à l'existence de tubes, cette solution a encore quelques inconvénients. Tout d'abord, les plaquettes de silicium placées dans les boîtes se trouvent dans une ambiance isostatique, c'est-à-dire qu'il n'y a que très peu ou pas de mouvements d'air. Dans ces conditions, les particules qui pourraient être présentes au voisinage des plaquettes sont principalement soumises aux forces d'attraction électrostatique qui se développent à la surface des plaquettes et sur les parois internes des boîtes. Comme la surface totale des plaquettes de silicium est beaucoup plus importante que celle des parois internes des boîtes, les particules se déposent surtout sur les plaquettes. Ceci est un inconvénient très important puisqu'on estime que, lorsqu'une particule ayant un diamètre de l'ordre de 0,2 micromètre est collée sur une surface propre, il est pratiquement impossible de l'en décoller. D'autre part, le système de tiroirs pour transférer les plaquettes d'une boîte à l'autre, ou d'une boîte à un équipement donné, doit être très précis. Les manoeuvres s'effectuent avec des frottements qui peuvent entraîner l'arrachement de particules et ces dernières risquent ensuite de se coller sur les plaquettes. Enfin, les divers équipements de fabrication doivent être équipés de conteneurs semblables aux boîtes étanches utilisées pour le transfert et l'installation de ces conteneurs est coûteuse et complexe.

La présente invention a pour but de remédier à ces inconvénients en proposant une installation de stockage et de transfert d'objets dans une atmosphère de haute propreté plus simple et moins coûteuse à mettre en oeuvre que celles de l'art antérieur.

Par ailleurs, le document EP-A-0 195 703 décrit une installation (conteneur et isolateur) de transfert d'objets, en vue de leur traitement, dans une atmosphère de haute propreté, comportant :
- des moyens de traitement desdits objets, en l'occurrence un plan de travail ;
- des moyens de transfert qui sont un conteneur étanche desdits objets entre des moyens quelconques de stockage et les moyens de traitement d'un desdits objets. Ces moyens de transfert sont constitués d'au moins un conteneur mobile pouvant s'accoupler aux moyens de traitement. L'installation comprend en outre des moyens de ventilation de tout l'intérieur de l'installation, à savoir des circuits d'épuration, pour soumettre en permanence lesdits objets à un flux de gaz de haute propreté.

Le principal objet de l'invention est une installation de stockage et de transfert d'objets, en vue de leur traitement, dans une atmosphère de haute propreté, placée dans un local de moyenne propreté, comportant :
- des moyens de stockage desdits objets ;
- des moyens de traitement desdits objets ;
- des moyens de transfert desdits objets entre les moyens de stockage et les moyens de traitement d'un desdits objets constitués d'au moins un conteneur mobile pouvant s'accoupler aux moyens de stockage et aux moyens de traitement ;
- des moyens de ventilation de tout l'intérieur de l'installation pour soumettre en permanence lesdits objets à un flux de gaz de haute propreté.

Elle se caractérise en ce que :
- lesdits moyens de stockage sont constitués d'une armoire comprenant :
  . au moins un filtre ayant une face amont et une face aval ;
  . des emplacements pour lesdits objets près de la face aval du filtre, le flux gazeux traversant le filtre de la face amont à la face aval de celui-ci ;
  . un premier caisson rigide dans lequel se trouvent des emplacements desdits objets

; et
  . au moins un deuxième caisson rigide dans lequel sont placés des moyens de mise en circulation du gaz se trouvant à l'intérieur de l'armoire (10), les deux caissons étant reliés l'un à l'autre par au moins un élément creux et souple (58, 60) apte à absorber les vibrations.

Un des éléments principaux de l'invention est une armoire ventilée constituant les moyens de stockage des objets.

Une caractéristique importante de l'installation selon l'invention est que les moyens de transfert comprennent également au moins un conteneur fixe servant à l'introduction desdits objets dans une machine de traitement.

Une autre caractéristique de l'invention est que les conteneurs fixe et mobile peuvent s'accoupler pour permettre le passage des objets de l'un dans l'autre.

De même, le conteneur mobile peut s'accoupler à l'armoire pour permettre le transfert des objets de l'un dans l'autre.

Selon une première réalisation de l'installation selon l'invention, les moyens de ventilation sont constitués de ventilateurs placés dans l'armoire et dans les conteneurs. La surpression est obtenue de la même manière.

Selon une deuxième réalisation de l'installation selon l'invention, les moyens de ventilation et de surpression sont constitués d'orifices permettant de mettre en communication l'intérieur de l'installation avec une source extérieure de gaz ultrapropre sous pression.

L'invention apparaîtra mieux à la lecture de la description qui va suivre, donnée à titre d'exemple purement illustratif et nullement limitatif, en référence aux dessins annexés, dans lesquels :
- la figure 1 est une vue schématique en coupe horizontale d'une armoire de stockage, utilisée dans l'installation selon l'invention,
- la figure 2 est une vue schématique de profil, en coupe verticale, de l'armoire de la figure 1,
- la figure 3 est une vue schématique en perspective d'un panier servant de support aux objets traités, et en particulier à des plaquettes de silicium,
- la figure 4 est une vue schématique en coupe verticale illustrant deux conteneurs selon une première réalisation de l'invention, dont l'un mobile, est utilisé pour le transfert des plaquettes de silicium et l'autre, fixe, sert de sas pour l'introduction des plaquettes dans une machine,
- la figure 5 est une vue schématique en perspective montrant certains éléments constitutifs des conteneurs illustrés à la figure 4,

- la figure 6 est une vue schématique de profil et partiellement en coupe illustrant le transfert de plaquettes entre un conteneur mobile de transfert et une machine selon une première réalisation de l'invention,
- la figure 7 est une vue schématique en perspective montrant le panneau avant de l'armoire de la figure 1 pendant une opération d'introduction ou d'extraction des plaquettes de l'armoire,
- la figure 8 est une vue schématique en coupe verticale à échelle agrandie illustrant l'ouverture des portes du panneau avant de l'armoire,
- la figure 9 est une vue schématique en coupe verticale illustrant une autre forme possible pour les alvéoles de stockage des plaquettes dans l'armoire.
- la figure 10 est une vue schématique représentant un conteneur conforme à une deuxième réalisation de l'invention ainsi que les liaisons entre celui-ci et la source de gaz ultrapropre,
- la figure 11 est un graphe montrant les variations de la pression et de la vitesse du gaz circulant à l'intérieur du conteneur de la figure 10,
- la figure 12 est une vue schématique en élévation montrant l'accouplement de deux conteneurs conformes à la deuxième réalisation de l'invention dont l'un est déplaçable à l'intérieur du local et dont l'autre sert de sas pour le transfert des plaquettes de silicium à l'intérieur d'une machine de traitement,
- la figure 13 est une vue schématique en coupe à échelle agrandie montrant les deux conteneurs de la figure 12 en position accouplée,
- la figure 14 est une vue schématique en coupe suivant la ligne XIV-XIV de la figure 13, mais illustrant une situation dans laquelle les portes des conteneurs sont en position ouverte,
- la figure 15 est une vue schématique en coupe verticale d'un conteneur conforme à la deuxième réalisation selon l'invention, et dans lequel la porte est remplacée par un rideau d'air,
- la figure 16 est une vue schématique en coupe montrant la disposition des buses servant à créer le rideau de gaz dans le conteneur de la figure 15, et
- la figure 17 est une vue semblable à la figure 15 montrant l'accouplement de deux conteneurs de ce type.

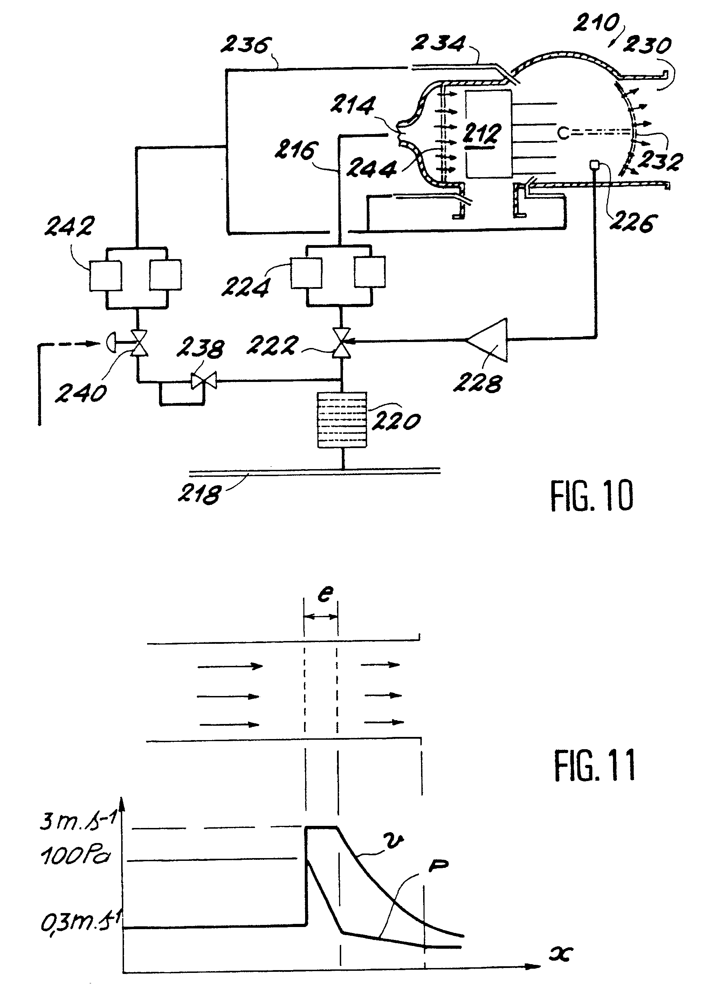

Relativement aux figures 10 à 17, concernant une deuxième réalisation possible des conteneurs fixes et mobiles, et aux passages de la description qui y sont relatifs, les mêmes termes que ceux utilisés avec la première réalisation seront employés pour désigner les pièces, ensembles ou objets analogues, c'est-à-dire, remplissant les mêmes fonctions.

Les principaux éléments constituant une installation selon l'invention sont :
- des moyens de stockage d'objets, constitués d'une armoire ;
- des moyens de traitement des objets, constitués de machines de traitement ou postes de travail ; et
- des moyens de transfert des objets entre l'armoire et les machines, constitués de conteneurs fixes et mobiles.

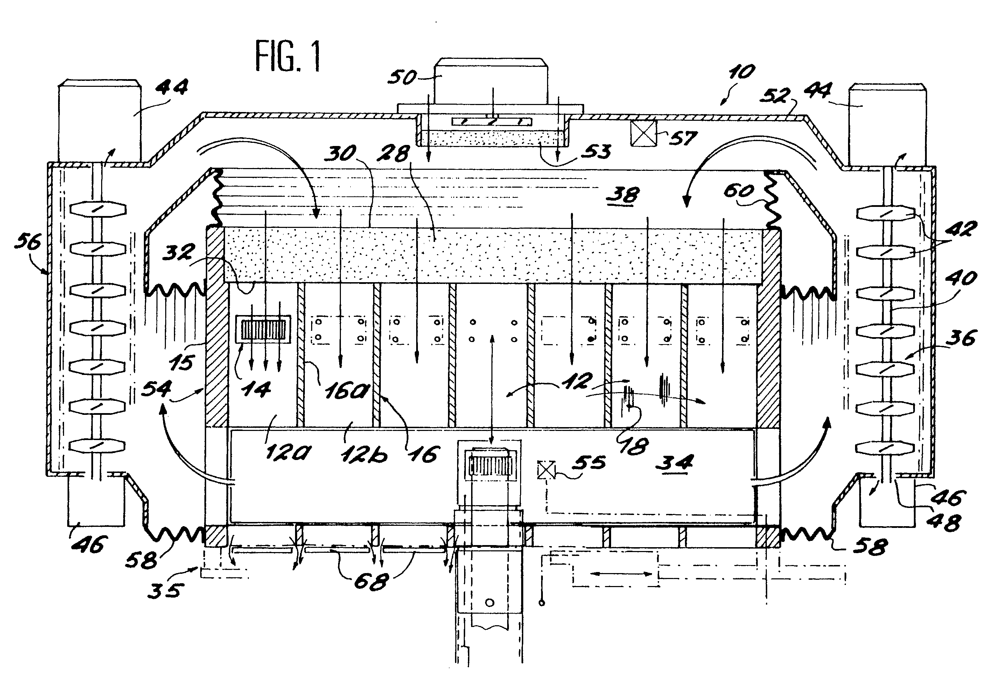

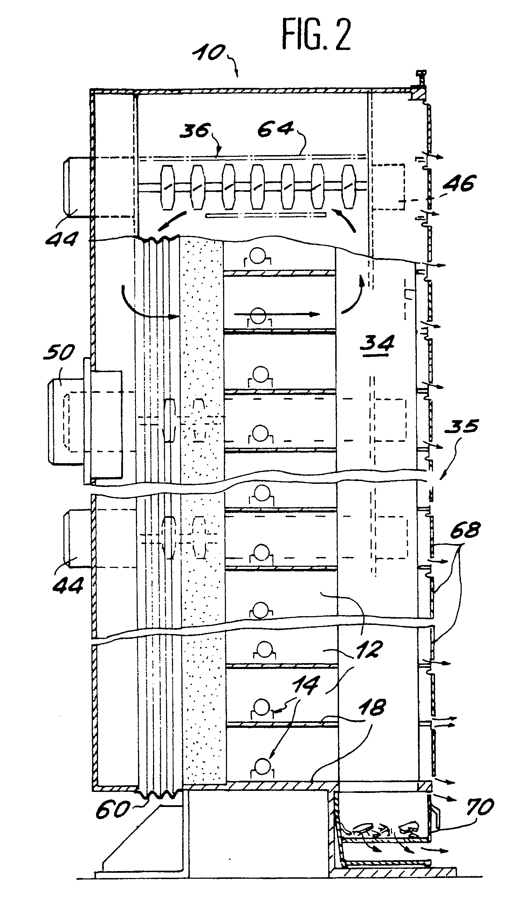

Les figures 1 et 2 illustrent une armoire de stockage 10 selon l'invention, servant pour des plaquettes de silicium ou d'un autre matériau, par exemple l'arséniure de gallium. Cette armoire comporte un certain nombre d'alvéoles 12 dans chacun desquels est stocké un panier 14 contenant des plaquettes de silicium. Chaque alvéole 12 est limité par deux cloisons verticales 16 qui le séparent des alvéoles adjacents et par un plancher horizontal 18 sur lequel est posé le panier 14. Les alvéoles sont disposés en rangées horizontales, tous les planchers des alvéoles d'une même rangée étant à la même hauteur, et il y a plusieurs rangées superposées. Un alvéole situé à l'extrémité d'une rangée, comme par exemple l'alvéole 12a, est limité d'un côté par une cloison 16a qui le sépare de l'alvéole adjacent 12b de la même rangée et de l'autre côté par une paroi 15. Les dimensions des alvéoles dépendent de la capacité des paniers (ceux-ci contiennent en général 25 ou 50 plaquettes) et du diamètre des plaquettes. Par exemple, pour des plaquettes ayant quatre pouces de diamètre, la hauteur de l'alvéole peut être de 12 cm et sa largeur de 18 cm.

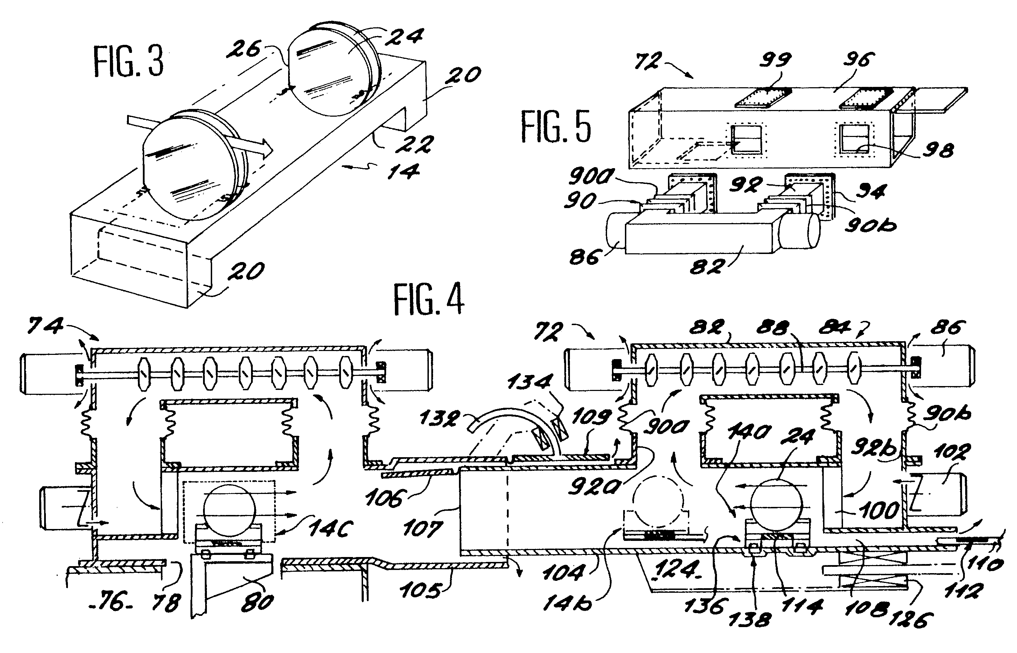

La vue en perspective de la figure 3 montre une forme particulière de panier destinée à faciliter la manutention et le transfert de celui-ci au cours des opérations de transfert entre l'armoire de stockage et les machines de traitement, opérations qui seront décrites ultérieurement. On voit que le panier 14 a la forme d'un support allongé présentant à ses deux extrémités des pieds 20 entre lesquels se trouve un évidement 22 permettant le passage d'un moyen de manutention. Les plaquettes 24 sont posées dans des logements prévus à la surface supérieure du panier, le plan des plaquettes étant vertical lorsque le panier est posé sur un support horizontal. La forme des paniers est telle que la surface des plaquettes en contact avec leur support soit la plus faible possible. De tels supports sont connus en soi et ne seront pas décrits en détail ici. On voit encore sur la figure 3 que chaque plaquette 24 comporte un méplat 26 servant à indiquer l'orientation cristallographique de la plaquette et à faciliter son positionnement correct dans les machines de traitement.

Si l'on se reporte à nouveau à la figure 1, on voit que selon l'invention des moyens de ventilation sont prévus à l'intérieur de cette armoire pour soumettre en permanence les objets stockés à un flux de gaz de haute propreté. En effet, un filtre ou une batterie de filtres 28, est placé en arrière des alvéoles 12. Dans le cas particulier décrit ici, le filtre 28 est absolu et comporte une face amont 30 et une face aval 32, les faces amont et aval du filtre étant verticales. Les cloisons 16, ainsi que le plancher 18, sont en contact, à l'une de leurs extrémités, avec la face aval du filtre de sorte que chaque alvéole est fermé à son extrémité correspondante par le filtre.

Des ventilateurs, qui seront décrits ci-dessous, permettent de faire circuler l'air à l'intérieur de l'armoire de sorte que celui-ci pénètre à travers le filtre par sa face amont 30 et en ressorte par sa face aval 32. Les paniers 14 sont placés sur le plancher 18 au voisinage immédiat de la face aval 32 du filtre 28 et ils sont disposés de sorte que le plan des plaquettes 24, c'est-à-dire leurs surfaces planes, soit parallèle à la direction d'écoulement de l'air à sa sortie du filtre. Ceci présente un double avantage tout d'abord, c'est de l'air qui est passé à travers un filtre absolu, donc de l'air très propre, qui balaye les plaquettes. D'autre part, comme la direction d'écoulement est parallèle aux surfaces planes des plaquettes, ceci a pour effet d'éliminer les éventuelles poussières qui pourraient se déposer sur celles-ci. La longueur des alvéoles est prévue suffisamment importante pour qu'il y ait, en aval des paniers 14 par rapport au sens d'écoulement de l'air, une longueur d'environ 30 cm afin d'éviter que les turbulences de l'air sortant des alvéoles ne viennent perturber l'environnement immédiat des plaquettes.

L'air sort des alvéoles par l'extrémité de ceux-ci opposée au filtre 28, qui est ouverte. Il arrive ainsi dans l'espace avant 34 de l'armoire. Cet espace est limité, du côté opposé aux alvéoles, par le panneau avant 35 de l'armoire : celui-ci, qui est vertical et placé parallèlement aux rangées d'alvéoles, sera décrit ultérieurement. L'espace 34 est ouvert à chacune de ses extrémités correspondant aux extrémités d'une rangée d'alvéoles : il communique ainsi, par les espaces situés entre le panneau avant 35 et les parois telles que 15, avec des caissons contenant des ventilateurs tels que 36. Ces ventilateurs sont disposés de manière à aspirer l'air se trouvant dans l'espace 34 et le refouler dans l'espace arrière 38 de l'armoire 10. Les dimensions de cet espace 38 sont déterminées afin d'homogénéiser la pression de l'air avant que celui-ci ne pénètre dans les filtres absolus.

Dans le mode de réalisation préféré décrit ici, les ventilateurs 36 se composent essentiellement d'un arbre 40 le long duquel sont montés plusieurs ensembles de pales 42. Afin d'éviter de transmettre des vibrations à l'armoire de stockage, le moteur d'entraînement 44, ainsi que les paliers tels que 46 pour le maintien de l'arbre, se trouvent à l'extérieur de l'armoire. L'arbre 40 traverse les parois de l'armoire à travers des orifices 48 dont la section est supérieure à celle de l'arbre. Cette disposition présente un double avantage : tout d'abord, il n'y a pas de contact entre l'arbre et la paroi de l'armoire, ce qui évite de transmettre à celle-ci les vibrations dues au mouvement de rotation de l'arbre. D'autre part, comme l'armoire est la plupart du temps maintenue en surpression par rapport au local, l'air peut s'écouler de l'intérieur vers l'extérieur de celle-ci à travers les orifices 48.

Afin d'obtenir une étanchéité dynamique de l'armoire, on maintient celle-ci en surpression par rapport au local de traitement. On a prévu un ventilateur annexe 50 monté sur la paroi arrière 52 de l'armoire. Le ventilateur 50 prélève de l'air dans le local et l'insuffle à l'intérieur de l'armoire à travers un filtre 53 placé dans un orifice de la paroi 52. Le ventilateur 50 est asservi au moyen de deux capteurs de pression dont l'un (non représenté) se trouve à l'extérieur de l'armoire et l'autre 55 à l'intérieur de celle-ci, dans l'espace avant 34. Avantageusement, on peut prévoir un régulateur de température et d'hygrométrie 57 dans la partie arrière 38 de l'armoire.

Les parties de l'armoire 10 où se trouvent les ventilateurs peuvent être le siège de vibrations. Bien que celles-ci ne soient pas gênantes vis-à-vis des plaquettes stockées, comme on doit être en ambiance extrêmement propre dans les alvéoles, il convient d'annuler tout frottement mécanique car les vibrations sont génératrices de particules. C'est pourquoi l'armoire 10 est constituée de deux parties principales : une première partie 54 se présente sous la forme d'un caisson rigide contenant les alvéoles, les filtres absolus et le panneau avant. Une deuxième partie 56 se présente sous la forme d'un deuxième caisson rigide entourant le premier sur les côtés et à l'arrière de celui-ci. Afin que les vibrations engendrées dans le caisson 56 par les ventilateurs ne soient pas transmises au caisson 54 contenant les alvéoles, les deux caissons sont reliés l'un à l'autre par des liaisons souples qui se présentent sous la forme de soufflets. Dans le cas particulier décrit ici, les liaisons sont assurées par deux soufflets latéraux 58 reliant l'espace avant 34 de l'armoire aux deux zones où se trouvent les ventilateurs. D'autre part, un troisième soufflet 60 relie la partie arrière du caisson 56 à la partie arrière du caisson 54 au voisinage de la face amont des filtres 28. On comprend que cette disposition assure un recyclage permanent de l'air contenu à l'intérieur de l'armoire lorsque les ventilateurs 36 sont en fonctionnement : l'air traverse les alvéoles depuis le filtre 28 jusqu'à l'espace 34, passe ensuite de cet espace dans les parties du caisson 56 contenant les ventilateurs 36 à travers les soufflets 58, puis de ces parties du caisson 56 dans la partie arrière 38 de l'armoire à travers des zones de raccordement 59 et, de là, jusqu'à la face amont des filtres à travers le soufflet 60. Les soufflets 58 et 60 sont de préférence fixés de manière étanche aux caissons 54 et 56 : cependant, si l'étanchéité n'est pas parfaite, ce n'est pas gênant dans la mesure où l'armoire est en surpression par rapport à l'extérieur.

S'il y a un nombre important de rangées d'alvéoles superposées, comme cela est illustré à la figure 2, on peut prévoir plusieurs ventilateurs tels que 36 placés les uns au-dessus des autres de chaque côté de l'armoire 10. Eventuellement, afin d'éviter des turbulences, on peut placer chaque ventilateur, ou du moins la partie de chaque ventilateur contenant les pales 42, à l'intérieur d'un cylindre creux 64 (figure 2). De préférence, les pales des ventilateurs sont polies et métallisées afin d'avoir un aspect de surface brillant et la surface interne des cylindres 64 est polie comme celle des pales afin d'éviter des turbulences dues au frottement de l'air sur ces surfaces.

Il est à remarquer que le volume intérieur d'une telle armoire est relativement petit par rapport au volume du local dans lequel elle est entreposée. Aussi, dans un mode préféré de réalisation, on revêt l'ensemble des surfaces intérieures de l'armoire, c'est-à-dire non seulement la face interne des parois de celles-ci, mais également la surface des arbres et des pales des ventilateurs ainsi que les cloisons et les planchers des alvéoles, d'une couche mince d'un matériau qui est le matériau constitutif des plaquettes, par exemple le silicium. Ainsi, l'air circulant à l'intérieur de l'armoire n'est jamais en contact avec un matériau autre que le silicium.

On voit encore sur les figures 1 et 2 que le panneau avant 35 de l'armoire comporte un certain nombre de portes 68. Il y a une porte en face de chaque alvéole : il suffit donc d'ouvrir la porte correspondant à un alvéole donné et de venir prendre ou déposer le panier 14 par un moyen de préhension extérieur à l'armoire. Les portes, ainsi que les moyens de préhension, seront décrits ci-dessous lorsqu'on décrira le transfert d'un panier entre l'armoire de stockage et une machine de traitement. A titre d'exemple, le volume utile de stockage, c'est-à-dire l'ensemble des alvéoles, peut avoir une hauteur de 2,4 m et une largeur de 4,32 m. Si la section de chaque alvéole est de 12 × 18 cm, on peut loger 24 alvéoles dans une rangée et superposer 20 rangées, soit au total 480 alvéoles pour des plaquettes d'un diamètre de 4 pouces. Si les paniers contiennent 50 plaquettes, on pourra ainsi stocker soit 24 000 plaquettes de diamètre 4 pouces, soit 6 000 plaquettes de diamètre 8 pouces.

Il se peut qu'au cours d'une manutention, lorsqu'on vient déposer un panier dans son alvéole ou l'en retirer, une fausse manoeuvre conduise à la chute du panier ou de quelques plaquettes seulement. C'est pourquoi on a prévu, à la partie inférieure de l'espace avant 34 de l'armoire, un tiroir 70 qui permet de récupérer les objets brisés ou souillés. On peut prévoir la forme et les dimensions de ce tiroir afin que l'air qu'il contient, qui est en surpression par rapport au local, puisse s'échapper à l'extérieur, soit par dessus le rebord supérieur du tiroir, soit en dessous de celui-ci : dans ce cas, le plancher du tiroir peut être perforé.

Afin que l'armoire soit utilisable quel que soit le diamètre des plaquettes à stocker, on peut prévoir que chaque alvéole est fixe en largeur (cette largeur étant fonction du nombre de plaquettes dans le panier) et peut être ajusté en hauteur. En cas de changement de diamètre des plaquettes à stocker, le panneau avant est prévu démontable afin qu'il puisse être retiré et remplacé par un autre dont les portes correspondent aux nouvelles dimensions des alvéoles. Ainsi, seuls les alvéoles et le panneau avant sont modifiés, tout le reste de l'armoire demeurant inchangé.

On va maintenant décrire une opération de transfert d'objets, c'est-à-dire des plaquettes, entre l'armoire de stockage et une machine de traitement en référence aux figures 4 à 9.

La vue en coupe verticale de la figure 4 montre deux conteneurs dont l'un 72 sert au transfert des plaquettes entre l'armoire de stockage et une machine 76 tandis que l'autre 74 sert de sas pour le transfert des plaquettes entre le conteneur 72 et la machine 76. Dans l'exemple décrit ici, le conteneur 74 est placé sur la machine 76 et communique avec l'espace intérieur de celle-ci par une ouverture 78 prévue dans sa paroi inférieure. Cette ouverture permet le passage d'un ascenseur 80, faisant partie de la machine, cet ascenseur étant apte à transférer les plaquettes de l'intérieur du conteneur 74 à l'intérieur de la machine.

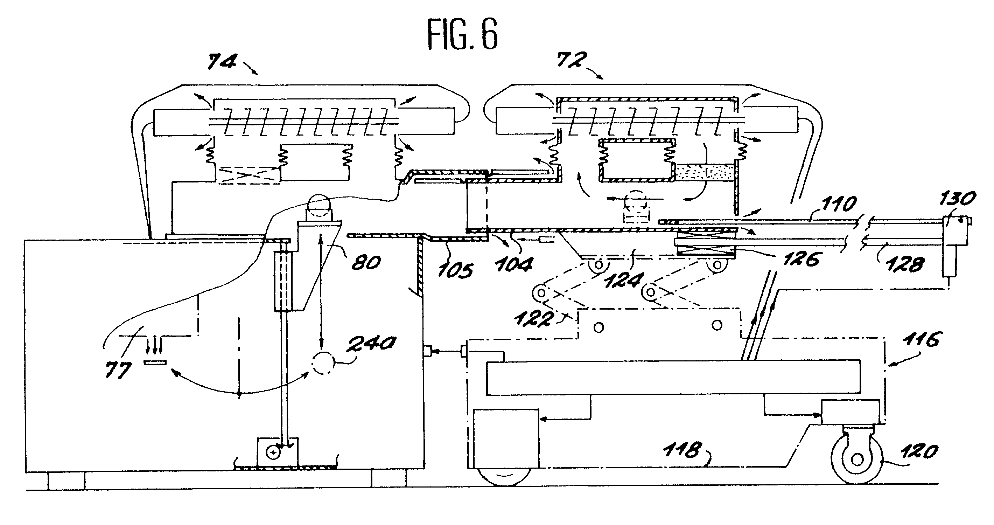

La vue en perspective de la figure 5 montre de manière schématique la structure générale d'un conteneur mobile tel que 72. On voit que celui-ci se compose d'abord d'un caisson rigide 82 à l'intérieur duquel se trouve un ventilateur 84, semblable aux ventilateurs 36 équipant l'armoire de stockage. Comme dans le cas de l'armoire, il est préférable que les moteurs 86 actionnant le ventilateur 84 ainsi que les paliers de maintien de l'arbre 88, se trouvent à l'extérieur du caisson 82 et que l'arbre 88 traverse les parois du caisson 82 à travers des orifices dont le diamètre est supérieur à celui de l'arbre. Le caisson 82, qui a une section carrée ou rectangulaire, est de forme allongée et il communique, à chacune de ses extrémités, avec un manchon rigide 92 par l'intermédiaire d'un soufflet 90. Ce manchon comporte, à son extrémité opposée au soufflet 90, une bride 94 qui permet de le fixer de manière étanche sur un autre caisson 96, chaque bride 94 étant placée autour d'une ouverture 98 prévue dans le caisson 96. Ainsi, le caisson 96 et les manchons 92 constituent le premier caisson rigide dans lequel se trouvent les plaquettes, tandis que le caisson 82 constitue le deuxième caisson dans lequel se trouve le ventilateur. Celui-ci permet donc une circulation permanente de l'air à l'intérieur du caisson, l'air étant aspiré à travers l'un des deux soufflets 90a et refoulé par l'autre 90b. Dans le cas particulier décrit ici, la direction générale des soufflets 90 et des manchons 92 est perpendiculaire à la direction générale des caissons 82 et 96, mais on ne sortirait pas du cadre de l'invention en utilisant une disposition différente.

Un filtre 100 est prévu dans le caisson 96 un peu en aval du raccordement avec le manchon 92b tandis que le panier 14 repose sur un emplacement situé sur la paroi inférieure du conteneur 72 immédiatement en aval du filtre 100. Là aussi, la disposition est telle que le plan des plaquettes soit parallèle à la direction d'écoulement de l'air afin que les deux faces de chaque plaquette soient balayées par un écoulement d'air laminaire. Comme dans le cas de l'armoire de stockage, le conteneur 72 est équipé d'un ventilateur annexe 102 placé de manière à insuffler l'air extérieur à l'intérieur du conteneur 72. Le ventilateur 102 est placé de préférence de manière à insuffler l'air extérieur en amont du filtre 100. Le filtre 100 est de préférence un filtre absolu.

On voit encore sur les figures 4 et 5 que le caisson 96 a la forme d'un parallèlépipède creux et que le caisson 82 est monté sur le caisson 96 de sorte que l'un des soufflets (90b) se trouve très près de l'une des extrémités du caisson 96 et que l'autre soufflet (90a) soit relativement éloigné de l'autre extrémité du caisson 96. La partie du caisson 96 située entre le point de raccordement du manchon 92a et l'extrémité du caisson 96 constitue ainsi un nez 104 dont la première extrémité communique avec l'intérieur du conteneur et la deuxième extrémité communique avec l'extérieur par une ouverture 107. Cette deuxième extrémité peut être obturée par une porte 106 fixée au rebord supérieur de l'ouverture 105 et pouvant pivoter autour d'un axe perpendiculaire au plan de la figure et passant au voisinage immédiat de ce rebord.

On voit encore sur la figure 4 qu'on a prévu, dans le conteneur 72, au voisinage du filtre 100, un passage 108 pour une tige de manutention 110. De préférence, la largeur du passage 108 est inférieure à celle du caisson 96 et ses dimensions sont juste suffisantes pour laisser passer la tige. Si nécessaire, on peut pratiquer une petite ouverture à la base du filtre 100 pour le passage de la tige. Celle-ci est manoeuvrée à l'aide d'un équipement qui sera décrit ci-dessous en référence à la figure 6 et comporte, à l'une de ses extrémités, un électroaimant 112 qui peut coopérer avec un aimant 114 prévu à la partie inférieure du panier 14. Ainsi, lorsque l'extrémité de la tige 110 est introduite sous le panier 14 et que l'électroaimant 112 est excité, le panier est maintenu sur l'extrémité de la tige et celle-ci peut être soulevée et déplacée en translation : on peut ainsi faire passer le panier de la position de départ 14a, qui est sa position normale dans le conteneur de transfert 72, à une position 14b représentée schématiquement en traits mixtes sur la figure. La longueur de la tige 110 est prévue suffisamment grande pour qu'elle puisse transporter le panier depuis la position de départ 14a jusqu'à la position 14c qui se trouve à l'intérieur du deuxième conteneur 74, au-dessus de l'ouverture 78.

On voit encore sur la figure 5 que des ouvertures telles que 98 pour la fixation des brides 94 peuvent être prévues sur n'importe quelle face du caisson 96. Si nécessaire, il est facile de retirer les brides 92 des ouvertures sur lesquelles elles sont fixées et de les placer sur une autre face du caisson 96, les ouvertures non utilisées étant obturées par des plaques 99. De même, en ce qui concerne le conteneur 74 servant à l'introduction des plaquettes dans la machine 76, il n'est pas nécessairement posé sur une face plane supérieure de la machine. Il peut être placé à côté de celle-ci de sorte qu'une paroi verticale du conteneur 74 soit au voisinage immédiat d'une paroi verticale de la machine. Dans ce cas, l'ouverture 78 se trouve sur cette paroi verticale tandis que la paroi de la machine présente une ouverture permettant le passage d'un moyen de préhension propre à la machine. Le conteneur 74 est constitué de la même manière que le conteneur 72 et ne sera pas décrit en détail ici.

On va maintenant décrire une opération de transfert des plaquettes depuis le conteneur de transfert jusqu'à l'intérieur de la machine et inversement, ainsi que le transfert de plaquettes depuis la machine jusqu'à l'armoire de stockage à l'aide du conteneur de transfert.

Ce dernier peut être manipulé par un opérateur car il est relativement léger et peu encombrant. Par exemple, sa longueur totale (depuis le ventilateur 102 jusqu'à la porte 106) peut être de l'ordre de 70 cm, tandis que le caisson 96 a une section carrée ou rectangulaire dont les dimensions sont inférieures à celles des alvéoles de stockage de l'armoire 10 : grâce à cette disposition, le nez 104 peut pénétrer non seulement à l'intérieur de l'armoire après ouverture de l'une des portes 68, mais également à l'intérieur de l'alvéole correspondant. Cependant, pour les raisons indiquées au début de la présente description, et notamment parce que les êtres humains sont générateurs de poussières, il est préférable que le conteneur de transfert 72 soit transporté de l'armoire de stockage 10 jusqu'au conteneur 74 par un robot.

Un tel robot est représenté schématiquement sur la figure 6 où l'on voit qu'il se compose essentiellement d'un chariot 118 reposant sur le sol par des roues 120. A la partie supérieure du chariot 118 sont montés des bras articulés 122 sur lesquels repose un support 124. Le conteneur 72 repose sur ce support 124 tandis que les bras 122 sont mobiles entre une position basse et une position haute, ce qui leur permet d'amener le conteneur 72 à la hauteur voulue. Sur le support 124 est monté un électroaimant 126 qui permet d'agir sur une tige 128. Les mouvements de la tige 128 sont transmis à la tige 110 par l'intermédiaire d'un dispositif de liaison 130.

Si le conteneur est transporté par un opérateur humain, il doit être relié par des fils de connexion à un chariot contenant tous les instruments de commande et notamment l'alimentation électrique des moteurs du ventilateur. Dans le cas où le transfert est effectué à l'aide du robot 116, celui-ci comporte toutes les commandes et, en particulier, l'alimentation électrique des ventilateurs.

Le transfert d'un panier de plaquettes entre le conteneur de transfert 72 et la machine 76 se fait de manière suivante :

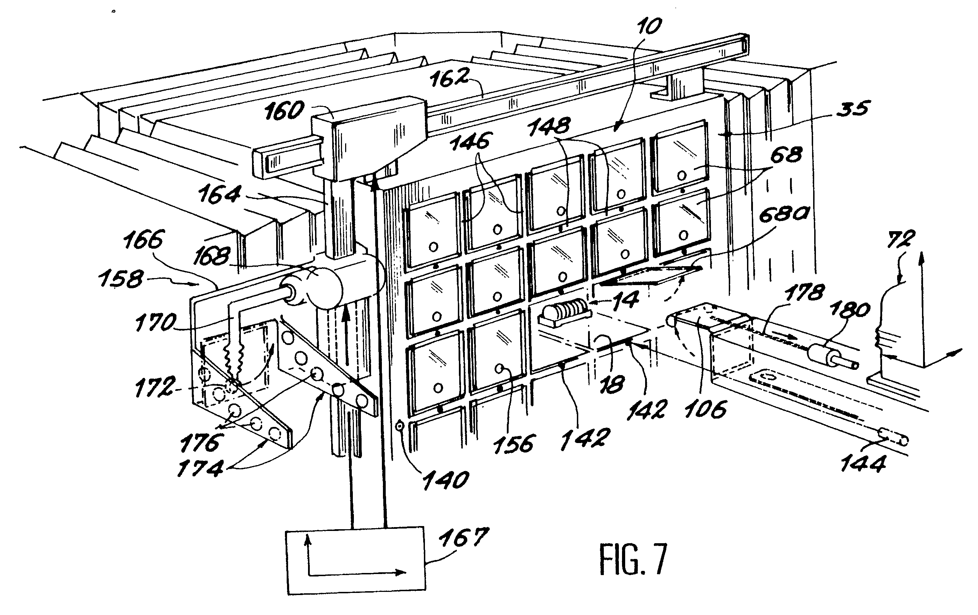

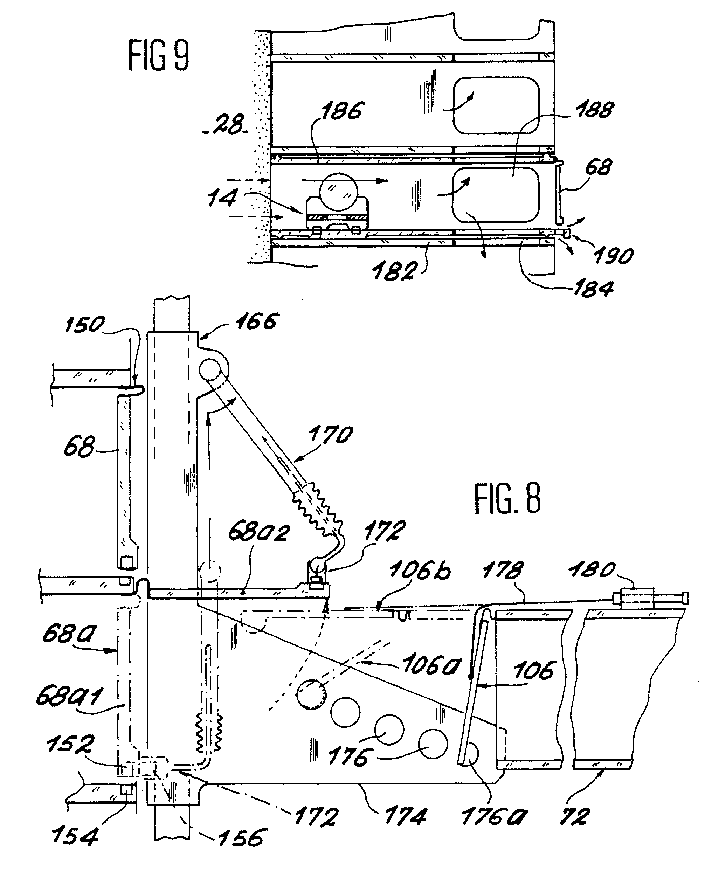

Lors du transfert entre l'armoire de stockage et la machine, le panier 14 occupe la position 14a illustrée à la figure 4, tandis que la porte 106 du conteneur 72 est fermée, c'est-à-dire qu'elle est en position verticale. Le conteneur 72 repose sur le support 124 du robot 116. Lorsque ce dernier approche de la machine 76, on règle la position des bras 122 afin que le nez 104 du conteneur 72 soit à la même hauteur que le nez 105 du conteneur 74. A ce moment, on ouvre la porte 109 du conteneur 74. Celle-ci est montée comme la porte 106 du conteneur 72. L'ouverture de la porte 109 peut être obtenue de la manière suivante : on a prévu, sur la partie extérieure de cette porte, un bras recourbé 132 qui passe dans l'entrefer d'un électroaimant 134 fixe par rapport au conteneur 74. Lorsque la porte 109 est en position fermée, c'est-à-dire verticale, seule l'extrémité du bras 132 se trouve dans l'entrefer de l'électroaimant. Lorsqu'on excite celui-ci, le bras 132 est attiré et il se lève, ce qui a pour effet d'ouvrir progressivement la porte. Quant à l'ouverture de la porte 106 du conteneur 72, elle peut être obtenue grâce à deux séries d'aimants montés dans le nez 105 du conteneur 74. Une telle série d'aimants est semblable à celle qui peut être utilisée dans le système d'ouverture des portes de l'armoire de stockage et qui sera décrite ci-dessous en référence aux figures 7 et 8.

Lorsque le conteneur 72 se trouve à la bonne hauteur et que la porte 109 du conteneur 74 est ouverte, on ouvre la porte 106 du conteneur 72 et on déplace le robot 116 de sorte que le nez 104 du conteneur 72 pénètre légèrement à l'intérieur du nez 105 du conteneur 74. Comme les deux conteneurs sont en surpression par rapport à l'extérieur, l'air présent à l'intérieur des deux conteneurs, qui est de très haute propreté, peut s'échapper à l'extérieur à travers les espaces entre les nez des deux conteneurs. L'électroaimant 126 du support 124 (figure 6) est excité afin que les tiges 128 et 110 qui se trouvaient jusqu'alors en position rétractée (c'est-à-dire pratiquement la position illustrée aux figures 4 et 6) avancent vers la gauche en regardant les figures 4 et 6 jusqu'à ce que l'aimant 112 de la tige 110 se trouve au-dessous de l'aimant 114 du panier 14. L'évidement 22 prévu à la partie inférieure du panier (figure 3) permet le passage de l'extrémité de la tige 110. Lorsque les aimants 112 et 114 sont en contact l'un avec l'autre, l'électroaimant 112 est excité afin que le panier 14 reste maintenu à l'extrémité de la tige. Cette dernière est légèrement soulevée par exemple par l'intermédiaire des moyens de liaison 130), et elle est déplacée vers la gauche en regardant à la figure 4 jusqu'à ce que le panier 14 occupe la position 14c à l'intérieur du conteneur 74, au-dessus de l'ouverture 78. L'ascenseur 80 de la machine est alors amené en position haute (sa position illustrée à la figure 4) et la tige 110 est abaissée pour que le panier repose sur l'ascenseur. L'aimant 112 est désexcité et la tige 110 est reculée. L'ascenseur 80 est mis en mouvement vers le bas à l'intérieur de la machine (figure 6) jusqu'à ce que les plaquettes arrivent en une position 24a représentée schématiquement en traits mixtes. Elles peuvent alors être transportées jusqu'à un poste de travail 77.

Lorsque le traitement à l'intérieur de la machine est terminé et qu'il faut ramener les plaquettes à l'intérieur de l'armoire de stockage, on opère de la manière suivante : à l'intérieur de la machine, les plaquettes sont transportées du poste de travail 77 à la position 24a et l'ascenseur 80 les ramène à l'intérieur du conteneur 74. La tige 110 est déplacée jusqu'à ce que son extrémité arrive sous le panier 14, l'électroaimant 112 est excité et la tige 110 est légèrement soulevée. L'électroaimant 126 est alors excité afin que l'ensemble des tiges 128 et 110 soit déplacé vers la droite en regardant les figures 4 et 6 jusqu'à ce que le panier 14 revienne à sa position 14a à l'intérieur du conteneur 72.

Afin de mieux maintenir le panier en position à l'intérieur du conteneur 72 pendant le transfert, on a prévu des aimants 136 sur les pieds du panier qui coopèrent avec des aimants 138 prévus dans la paroi inférieure du conteneur.

La tige 110 peut ensuite être ramenée à sa position de départ, illustrée à la figure 4, dans laquelle son extrémité n'est plus sous le panier 14. Le robot 116 est ensuite déplacé afin que le nez du conteneur 72 sorte du nez du conteneur 74. On désexcite l'électroaimant 134 afin que la porte 109 du conteneur 74 se referme, et on ferme également la porte 106 du conteneur 72. Le robot est alors déplacé et amené devant l'armoire de stockage 10 afin que le conteneur 72 se trouve dans une position telle que le caisson 96 ait sa plus grande longueur perpendiculaire au plan du panneau avant 35 de l'armoire (figure 7).

La mise en place du robot devant la porte choisie se fait à l'aide d'un capteur de ciblage d'origine 140 prévu sur un côté du panneau avant de l'armoire. Grâce à un détecteur 144, le robot se centre sur ce capteur qui peut être, par exemple, un capteur infrarouge, un détecteur de proximité ou tout autre dispositif équivalent. Le robot fait lui-même sa mise à zéro, puis son système informatique le conduit, à partir de cette position précise, jusqu'à la porte choisie, par exemple celle qui est référencée 68a sur la figure 7. Un second capteur 142, qui est un capteur de ciblage fin, permet au robot d'être parfaitement centré et parfaitement positionné devant la porte choisie, toujours grâce au détecteur 144. Il y a autant de capteurs 142 que de portes sur le panneau avant 35 de l'armoire. Ces capteurs peuvent être placés soit sur la porte elle-même, soit sur un autre élément du panneau 35, à n'importe quel endroit de celui-ci, le système informatique du robot étant programmé en conséquence.

Le panneau avant 35 de l'armoire 10 peut être constitué d'un ensemble de montants verticaux 146 et horizontaux 148 définissant ainsi des ouvertures de section carrée ou rectangulaire et dont les dimensions correspondent à celles des alvéoles. Les portes sont des panneaux carrés ou rectangulaires dont les dimensions sont voisines de celles des ouvertures ainsi définies. Dans le mode de réalisation préféré, chaque porte est fixée par son rebord supérieur à l'un des montants horizontaux 148 et peut pivoter autour d'un axe horizontal parallèle à ce montant. Afin d'éviter les frottements qu'on aurait avec des charnières classiques, frottements qui sont générateurs de particules et donc de poussières, les portes 68 sont montées sur le panneau avant 35 de l'armoire à l'aide de tôle fines déformables 150 (figure 8). La longueur de ces tôles est pratiquement celle du rebord supérieur des portes et chacune est fixée d'une part au montant horizontal 68 situé au-dessus de la porte et, d'autre part, à la partie supérieure de la porte elle-même. Ainsi, le mouvement de pivotement de la porte n'entraîne aucun frottement et seulement la déformation de cette tôle.

D'autre part, les dimensions des portes ne sont pas exactement celles des ouvertures définies par les montants 146 et 148, mais légèrement inférieures afin de laisser un passage d'environ 1 mm de large pour que l'air contenu à l'intérieur de l'armoire puisse s'échapper à l'extérieur lorsque l'armoire est maintenue en surpression par rapport au local. Une porte comme la porte 68a illustrée aux figures 7 et 8 est donc mobile entre une position de fermeture 68a1 dans laquelle elle est pratiquement verticale et une position d'ouverture 68a2 dans laquelle elle est pratiquement horizontale après un pivotement au cours duquel la tôle fine 150 a été déformée. Pour assurer le maintien de chaque porte en position de fermeture, et surtout afin d'éviter qu'elle ne s'ouvre trop sous l'effet de la surpression régnant à l'intérieur de l'armoire, on a prévu un système d'aimants : ce système comprend un premier aimant 152 à la partie inférieure de la porte, de préférence au milieu du rebord inférieur de celle-ci, et un deuxième aimant 154, fixe par rapport au panneau 35, qui peut être placé sur le montant horizontal 138 correspondant au bord inférieur de la porte et au milieu de celle-ci de manière à être en face de l'aimant 152. L'ouverture des portes se fait grâce à des poignées si l'ouverture est effectuée par un opérateur humain, soit à l'aide d'aimants 156 si on utilise un robot, comme cela va être décrit ci-dessous.

Un exemple d'un tel robot, portant la référence générale 158, est illustré aux figures 7 et 8. Celui-ci se compose d'abord d'un chariot 160 mobile le long d'un rail horizontal 162 fixé à la partie supérieure de l'armoire. Sur le chariot 160 est monté un rail vertical 164 le long duquel peut se déplacer un support 166. Les dimensions et la position respective des différents éléments constituant le robot 158 sont telles qu'au cours du déplacement du chariot 160 le long du rail 162, le rail vertical 164, le support mobile 166 et tous les éléments montés sur ce support restent devant le panneau avant 35 de l'armoire. Sur le support mobile 166 est fixé un moteur 168 qui commande un bras mobile 170. Celui-ci comporte une première partie horizontale mobile en rotation autour de son axe et une deuxième partie perpendiculaire à la première qui porte à son extrémité un aimant 172 apte à coopérer avec les aimants 156. Les mouvements du chariot 160 sur le rail 162 et du support 166 sur le rail 164 sont réglés par un dispositif de commande 167, qui peut éventuellement être lui-même commandé par le robot 116.

Lorsque le robot 116 de la figure 6 a amené le conteneur 72 en face de la porte choisie 68a, le chariot 160 est déplacé le long du rail 162 et le support 166 est déplacé verticalement le long du rail 164 jusqu'à ce que l'aimant 172 se trouve en face de l'aimant 156. L'aimant 172 peut être un électroaimant qui est excité au moment voulu par le dispositif de commande du robot 158. La mise en route du moteur 168 entraîne la rotation du bras 170 autour d'un axe horizontal et donc l'ouverture de la porte. Sur le support 166 se trouvent encore deux bras 174 constitués par des plaques planes perpendiculaires au panneau avant 35 de l'armoire 10. La distance entre les bras 174 est légèrement supérieure à la largeur d'une porte 68. Sur chacun des bras 174 est montée une série d'aimants 176 servant à l'ouverture de la porte 106 du conteneur 72 comme cela va être décrit ci-dessous.

Lorsque le robot 116 a amené le conteneur 72 en face de la porte choisie, mais à une certaine distance de cette dernière, le robot 158 est mis en mouvement jusqu'à ce que les bras 174 viennent encadrer cette porte. Le moteur 168 est mis en route afin que le bras 170 ouvre la porte 68a. Le robot 116 est alors avancé jusqu'à ce que la porte 106 du conteneur 72 arrive au voisinage de l'extrémité des bras 174 opposée au panneau 35. La porte 106 du conteneur est montée pivotante autour de son rebord supérieur au moyen d'une tôle fine, comme les portes de l'armoire. Lorsqu'on arrive dans la position illustrée sur la figure 8, la partie inférieure de la porte 106 est attirée par l'aimant 176a situé à l'extrémité du bras 174 opposé à l'armoire. Elle pivote donc dans le sens des aiguilles d'une montre en regardant la figure 8 et s'ouvre donc légèrement. Au fur et mesure que le robot 116 fait avancer le conteneur 72, la porte s'ouvre progressivement, attirée par les autres aimants 176. Il est à remarquer que la ligne constituée par les aimants 176 est inclinée par rapport à l'horinzontale et s'élève progressivement depuis l'aimant d'extrémité 176a. Cependant, afin d'éviter que la porte ne revienne à sa position de fermeture, par exemple à cause de l'attraction des aimants qu'elle a déjà franchis, on a prévu un dispositif de maintien constitué d'un ruban métallique souple 178 dont une extrémité est fixée sur la face externe de la porte 106. Un électroaimant 180 agit sur ce ruban afin de le maintenir constamment en tension au fur et à mesure que la porte 106 s'ouvre, ce qui empêche cette dernière de retomber. La porte 106 passe ainsi par un certain nombre de positions intermédiaires 106a jusqu'à la position d'ouverture 106b dans laquelle elle est pratiquement horizontale. Le robot 116 continuant à se déplacer, le nez 104 du conteneur 72 pénètre à l'intérieur de l'armoire. En effet, les dimensions de ce nez sont prévues de telle sorte que le nez du conteneur 72 puisse non seulement pénétrer à l'intérieur de l'armoire, mais éventuellement pénétrer à l'intérieur des alvéoles où sont stockés les paniers de plaquettes.

Lorsque le conteneur 72 est ainsi en position, la tige 110 est mise en mouvement afin de tranférer le panier 14 de l'intérieur du conteneur 72 au fond de l'alvéole choisi. Cette opération est effectuée de la même façon que le transfert des paniers entre le conteneur 72 et l'ascenseur 80 de la machine 76 (figure 4) et ne sera pas décrite en détail ici. Lorsque le panier est posé dans son alvéole, la tige 110 est retirée, le robot 116 se recule et on referme la porte 106 du conteneur 72 en désexcitant progressivement l'aimant 180 pour détendre progressivement le ruban 178. Le bras 170 du robot 158 est mis en rotation de manière à refermer progressivement la porte 68a et on désexcite l'aimant 172 : le robot 158 peut être alors amené à une autre position, c'est-à-dire soit devant une autre porte, soit à une position de repos ou d'attente.

L'opération consistant à aller chercher un panier à l'intérieur de l'armoire pour le transporter ailleurs s'effectue de la manière suivante :

Le robot 116 est amené en face de la porte correspondante, ainsi que le robot 158. On ouvre la porte de l'armoire comme décrit ci-dessus et les opérations d'approche du conteneur et d'ouverture de la porte 106 de celui-ci se font également de la même façon. La tige 110 est alors avancée jusqu'à ce qu'elle arrive sous le panier, elle soulève celui-ci et l'amène à son emplacement à l'intérieur du conteneur 72, comme dans le cas où le panier est extrait de la machine. Le robot 116 est reculé, et on ferme la porte de l'armoire ainsi que la porte 106 du conteneur 72.

La figure 9 illustre une autre disposition possible pour les alvéoles de l'armoire de stockage. Dans le cas des figures 1 et 2, les alvéoles sont limités par des cloisons 16 et des tôles horizontales 18 dont les dimensions sont telles que l'espace avant 34 de l'armoire est entièrement dégagé. Cependant, on ne sortirait pas du cadre de l'invention en utilisant des casiers 182 (figure 9) en forme de parallélépipèdes rectangles ouverts à chacune de leurs deux extrémités et dont la longueur est égale à la distance entre la face aval du filtre 28 et le panneau avant de l'armoire. Bien entendu, dans la zone de ces casiers située près de la porte 68, on prévoit des ouvertures 184 sur chaque côté afin de laisser passer l'air dans l'espace 34. Dans ce cas, les paniers 14 sont placés dans des tiroirs 186 dont la section est semblable à celle des casiers 182, mais plus petite, afin que le tiroir 186 puisse pénétrer à l'intérieur du casier 182. Le tiroir a la même longueur que le caiser 182 et il est également équipé d'ouvertures 188 au voisinage de la porte 68 afin de laisser passer l'air. Le tiroir 186 peut être équipé d'une poignée ou d'un aimant 190 situé à l'extérieur de l'armoire et au voisinage du bord inférieur de la porte 68 : cette disposition permet de déplacer le tiroir vers l'extérieur de l'armoire grâce à la poignée ou à l'aimant 190 pour que le panier 14 soit rapproché des moyens de préhension du conteneur 72.

Les figures 10 à 17 sont relatives à une deuxième réalisation des conteneurs fixe et mobile selon l'invention.

Si l'on se reporte à la figure 10, on voit que le conteneur objet de la deuxième réalisation de l'invention, portant la référence générale 210, comporte à l'intérieur un emplacement pour le ou les objets à traiter. Ceux-ci peuvent être, comme cela sera décrit plus en détail ci-après, des plaquettes de silicium placées sur un support 212.

Selon cette deuxième réalisation de l'installation selon l'invention, les moyens pour créer la surpression et pour faire circuler le gaz à l'intérieur de l'installation sont constitués d'une source extérieure de gaz ultrapropre sous pression.

Le conteneur 210 présente un orifice d'entrée 214 qui lui permet, par l'intermédiaire d'une conduite 216, d'être en communication avec une canalisation 218 elle-même reliée à la source de gaz ultrapropre (non représentée). Cette dernière peut être de tout type connu, et en particulier être une source fournissant un gaz ultrapropre sous pression. Dans le mode de réalisation particulier illustré ici, la conduite 216 comporte, en allant de la conduite 218 au conteneur 210, d'abord un filtre à charbon actif 220, puis un régulateur de pression 222 et enfin une batterie de filtres haute pression 224. Il est à noter que la présence du filtre à charbon actif 220 et des filtres 224 n'est pas indispensable. Leur utilisation dépend de la propreté de l'air qui est fourni par la source et ces éléments peuvent éventuellement être incorporés au système permettant d'obtenir de l'air ultrapropre sous pression. L'essentiel est que le gaz pénétrant à l'intérieur du conteneur par l'orifice d'entrée 214 ait la propreté voulue pour l'utilisation envisagée. Quant au régulateur de pression 222, il est en relation avec un capteur de pression 226, situé à l'intérieur du conteneur 210, par l'intermédiaire d'un dispositif d'asservissement 228. On peut ainsi agir sur le débit de gaz circulant à l'intérieur de la conduite 216 afin de maintenir une pression constante à l'intérieur du conteneur 210.

En ce qui concerne l'armoire de stockage, la mise en communication de celle-ci avec la source extérieure de gaz ultrapropre peut s'effectuer en supprimant le ventilateur 50 (figure 1) et en le remplaçant par un raccord avec la canalisation reliée à la source de gaz.

On voit encore sur la figure 10 que le conteneur présente, du côté opposé à l'orifice d'entrée 214, un orifice 230 de sortie de l'air qui traverse ce conteneur en balayant les objets à traiter. Dans la position illustrée à la figure 10, l'orifice de sortie est fermé par une porte 232 qui se présente sous la forme d'un panneau ayant un certain nombre d'ouvertures de petite dimension. Comme on le verra plus loin, cette diposition fait que le gaz passant à travers les orifices a une vitesse élevée, ce qui permet d'éviter le dépôt de particules au niveau des orifices et empêche les particules se trouvant dans le local de pénétrer à l'intérieur du conteneur.

Cette disposition permet d'obtenir en quelque sorte un "mur d'air" sur une longueur e comme cela est illustré sur la figure 11. Celle-ci est un graphe qui donne, en fonction de l'emplacement x à l'intérieur du conteneur et à l'extérieur de celui-ci, les variations de la pression P (exprimée en pascals) et de la vitesse v (exprimée en mètres par seconde). Les dimensions du conteneur peuvent être, par exemple, de 300 mm de longueur, 120 mm de largeur et 160 mm de hauteur avec un taux de fuite d'air d'environ 20% du flux frontal. Le taux de fuite d'air est la proportion du débit d'air qui ne sort pas du conteneur à travers la porte, mais dans les autres interstices du conteneur (espace entre la porte et les parois du conteneur, fuites au niveau des éléments qui traversent les parois du conteneur, etc.). Le débit de gaz balayant un tel conteneur peut être de l'ordre de 25 m$^3$ par heure. On voit sur la figure 11 qu'à l'intérieur du conteneur, la vitesse v est par exemple de 0,3 m.s$^{-1}$. Puis, au niveau de la porte, la vitesse augmente brusquement pour arriver à une valeur de l'ordre, par exemple, de 3 m.s$^{-1}$ sur la distance e, puis la vitesse diminue progressivement à l'extérieur du conteneur pour reprendre sa valeur initiale et éventuellement s'annuler à grande distance de celui-ci. Quant à la surpression, elle est par exemple de 100 Pa à l'intérieur du conteneur puis, à partir de la porte, elle diminue pour atteindre des valeurs nettement plus faibles. Il est à noter que, sur la figure 11, la valeur P représente en fait la différence de pression entre l'intérieur du conteneur et le loal et non pas la pression absolue du gaz. La chute de pression entre l'intérieur et l'extérieur du conteneur est de l'odre de 50 à 800 Pa.

Si l'on se reporte à nouveau à la figure 10, on voit le système qui permet de nettoyer l'intérieur du conteneur par des jets de gaz ultrapropre sous pression orientés dans des directions déterminées. On voit que ce système se compose d'un certain nombre de buses 234 reliées par des conduites telles que 236 à la conduite 218 qui met le dispositif en communication avec la source de gaz ultrapropre. Lorsqu'on désire procéder à ce nettoyage, on ferme le régulateur 222 et le gaz provenant de la conduite 218 passe d'abord dans le filtre à charbon actif 220, puis dans le régulateur de pression 238, une vanne d'arrêt télécommandée 240 et, enfin, une batterie de filtres absolus 242. Cette diposition permet, lorsqu'il n'y a pas d'objet à traiter à l'intérieur du conteneur, de nettoyer l'intérieur de celui-ci par soufflage d'air ultrapropre à des endroits bien déterminés. Le nombre et la disposition des buses 234 dépendent des endroits où ce nettoyage est nécessaire. Bien entendu, l'homme du métier pourra faire varier le nombre et la disposition des éléments situés entre la conduite 218 et les buses 234 en fonction de chaque cas particulier.

Enfin, la figure 10 montre qu'on peut prévoir, entre l'orifice d'entrée 214 et le support 212 sur lequel sont placés les objets à traiter, une grille 244 servant de diffuseur d'air afin d'obtenir un jet laminaire au niveau des objets à traiter. Comme on le verra plus loin, cette grille peut être mise sous tension électrique et être utilisée comme ioniseur.

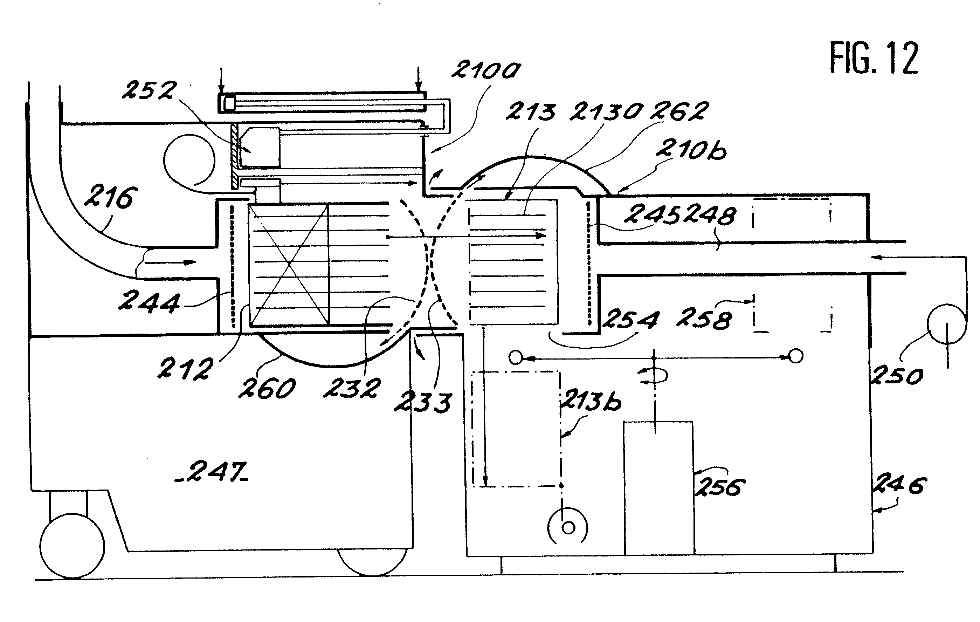

La figure 12 montre comment on peut accoupler deux conteneurs conformes à l'invention afin de réaliser le transfert de plaquettes de silicium à l'intérieur d'une machine de traitement.

Sur la figure 12, on voit un premier conteneur 210a, monté sur un chariot 247, qui permet le transfert de plaquettes de silicium entre une armoire de stockage (non représentée) et une machine de traitement 246. Un deuxième conteneur 210b, de même type que le conteneur 210a, est monté sur la machine 246. le conteneur 210b peut faire partie intégrante de cette machine, ou éventuellement être posé simplement sur cette dernière.

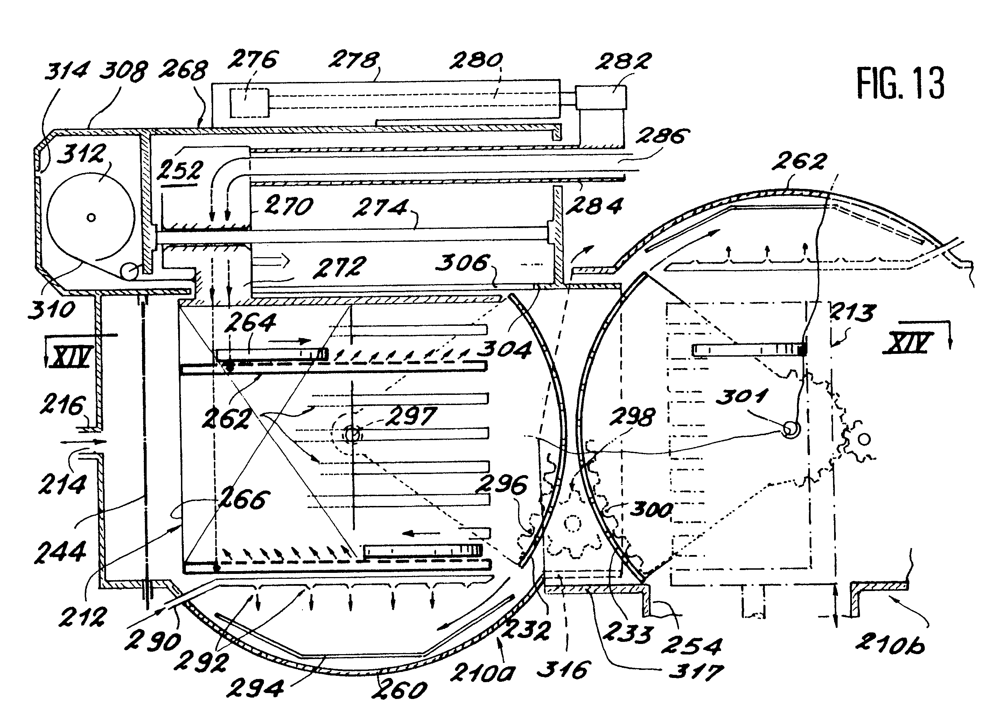

On voit sur la figure 12 la conduite 216 reliant le conteneur 210a à la source de gaz sous pression ainsi qu'une conduite 248 reliant le conteneur 210b à cette même source ou une autre, par exemple par l'intermédiaire d'une pompe 250. Le support 212 à l'intérieur du conteneur 210a est mobile à l'intérieur de ce dernier grâce à un dispositif de préhension et de levage 252 dont le fonctionnement sera expliqué plus en détail ci-après en référence à la figure 13. Le déplacement du support 212 permet de transférer les plaquettes de silicium sur un support 213 se trouvant à l'intérieur du conteneur 210b. Ce dernier présente à sa partie inférieure une ouverture 254 qui le met en communication avec l'intérieur de la machine 246. Le support 213 est mobile entre une position 213a, représentée en traits pleins, dans laquelle il est à l'intérieur du conteneur 210b et une position 213b, représentée schématiquement en traits mixtes, dans laquelle il se trouve à l'intérieur de la machine 246. Un dispositif 256 situé à l'intérieur de la machine 246 permet de transporter les plaquettes de silicium à l'intérieur de cette machine entre la position 213b du support 213 et un poste de travail 258.

Enfin, chacun des conteneurs 210a et 210b présente des logements 260, 262 où se trouvent les portes 232 et 33, respectivement, lorsqu'elles sont en position ouverte. On retrouve sur la figure 12 la grille 244 équipant le conteneur 210a et, si nécessaire, une grille semblable 245 équipant le conteneur 210b.

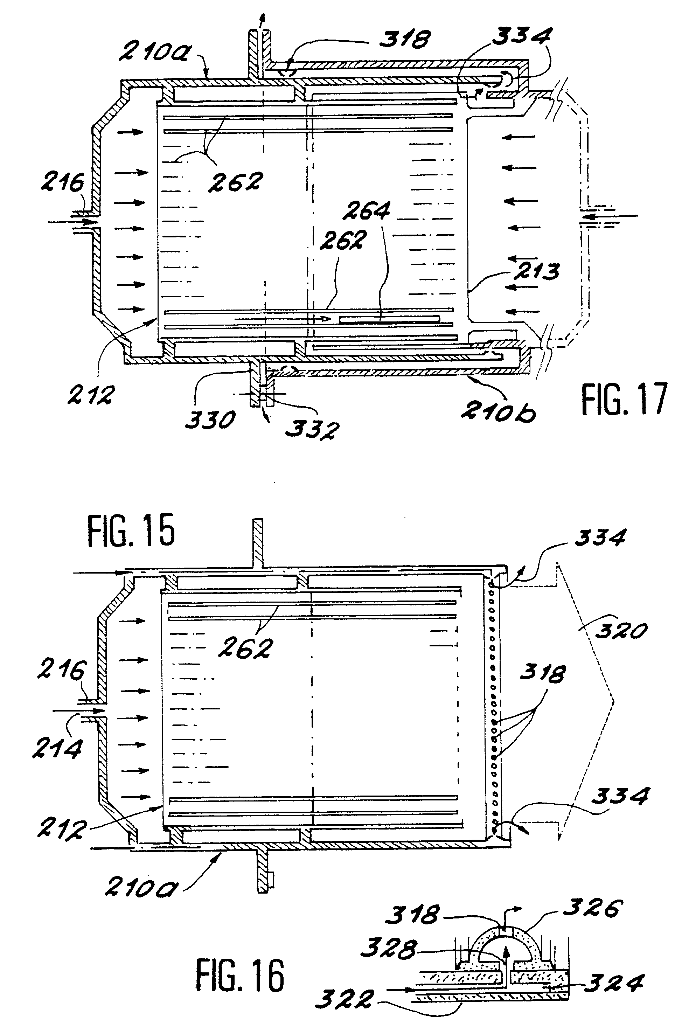

On va maintenant décrire plus en détail les conteneurs 210a et 210b ainsi que la procédure d'accouplement de ces deux conteneurs et le transfert des plaques de silicium de l'un à l'autre en référence aux figures 13 et 15.

On retrouve sur ces figures le conteneur 210a relié à la source de gaz ultrapropre par la conduite 216 et muni de la grille 44 située entre son orifice d'entrée 214 et le support 212. Ce dernier présente un empilement de pistes 262 sur chacune desquelles se trouve une plaquette de silicium 264. Chacune de ces plaquettes est maintenue sur la piste correspondante par un coussin d'air, l'air étant insufflé à l'intérieur de chacune des pistes et sortant de celle-ci par des ouvertures prévues dans la face supérieure de chaque piste. Une partie de chacune des pistes se trouve à l'intérieur d'un boîtier 266 (du côté gauche en regardant la figure 13) tandis qu'une autre partie se trouve à l'extérieur du boîtier.

Un carter 268 placé au-dessus du conteneur 210a renferme le système de préhension et de levage 252. Celui-ci comprend essentiellement un électroaimant 270 relié au support 212 par un élément de liaison rigide 272. L'électroaimant permet de soulever et de reposer à volonté le support 212 à l'intérieur du conteneur 210a. Une tige 274 horizontale sert de guide pour un déplacement en translation horizontale du dispositif 252. Un piston 276, mobile à l'intérieur d'un carter 278 situé au-dessus du carter 268, est relié par une tige 280 à un élément 282, lequel est relié par un tube 284 à l'électroaimant 270. Comme tous les éléments 276, 280, 282, 284 et 270 sont rigides, le déplacement du piston 276 grâce à des moyens moteurs (non représentés) entraîne le déplacement dans le même sens de l'électroaimant 272. Des fils ou conduites 286 cheminant le long du tube 284 permettent d'amener aux pistes 262 du support 212 l'énergie électrique et le gaz sous pression nécessaires au fonctionnement de ce dernier.

On voit encore sur la figure 13 que le carter 268 est séparé du reste du conteneur par une paroi 304 présentant une fente 306 sensiblement parallèle à la tige 274. L'élément de liaison 272 circule à l'intérieur de cette fente lorsque l'électroaimant 270 se déplace de gauche à droite et inversement en regardant la figure 13. Le dispositif comporte en outre, à l'intérieur d'un carter 308 communiquant avec le carter 268, une bande de masquage 310 montée sur un enrouleur 312. En fait, l'une des extrémités de la bande est fixée à l'enrouleur 312 tandis que son autre extrémité est fixée soit à l'électroaimant 270, soit à l'élément de liaison 272. Lorsque le système 252 se déplace de la gauche vers la droite en regardant la figure 13, ceci a pour effet de mettre le conteneur 210a et le carter 268 en communication par la fente 306. Cependant, comme une extrémité de la bande 310 est fixée à ce dispositif, celle-ci recouvre la fente 306 au fur et à mesure de ce mouvement, limitant ainsi le passage d'éventuelles poussières des carters 268 ou 308 au conteneur. Comme le carter 308 présente un orifice 314 le mettant en communication avec l'extérieur du conteneur, c'est-à-dire avec le local dans lequel se trouve ce conteneur, l'air pénétrant dans le conteneur 210a passe de celui-ci dans le carter 268 à travers la fente 306, puis dans le carter 308 et, de là, dans le local à travers l'orifice 314.

On voit encore sur la figure 13 que chacun des conteneurs 210a et 210b présente un logement 260, 262 respectivement dans lequel se trouvent les portes 232 et 233 lorsqu'elles sont en position ouverte (la figure 13 représente ces portes en position fermée). Un tube 290 percé d'ouvertures 292 est prévu à l'intérieur du logement 260 et il est en liaison avec la source de gaz ultrapropre. Ainsi, même lorsque la porte est en position ouverte, le tube 290 permet d'insuffler dans le logement 260 de l'air ultrapropre sous pression et les orifices des panneaux constituant les portes sont traversés par un gaz ultrapropre à grande vitesse. On maintient ainsi en permanence les portes dans un état de haute propreté et on évite, même lorsque les portes sont en position ouverte, le dépôt de particules sur ces dernières.

Les portes peuvent être constituées par exemple d'une toile très fine tissée de transparence comprise entre 0,1 et 0,2 et supportée par une armature rigide. Cette toile (dont l'épaisseur est de l'ordre de 150 à 200 micromètres) peut être de n'importe quelle forme, par exemple avoir la forme d'une portion de cylindre ou d'une portion de sphère. Les portes peuvent être réalisées en deux parties ou en une seule et le matériau constitutif des toiles peut être un métal (tissé ou fritté) ou un plastique (PVDF ou polysulfone).

Comme on l'a vu précédemment, à la traversée de cette porte transparente, la vitesse de l'air est multipliée par 5 à 10 et donc toute pollution est éloignée de la face externe du panneau. Le logement 262 pour la porte 233 du conteneur 210b est identique au logement 260 pour la porte 232 du conteneur 210a et ne sera donc pas décrit en détail ici.

On voit encore sur la figure 13, à l'intérieur du logement 260, une électrode 294 placée entre la paroi de ce logement et la porte 232 lorsque celle-ci est en position ouverte. Cette électrode peut être portée à un potentiel électrique déterminé afin d'attirer les particules qui pourraient se déposer accidentellement sur la porte et maintenir celle-ci dans un état de très haute propreté.

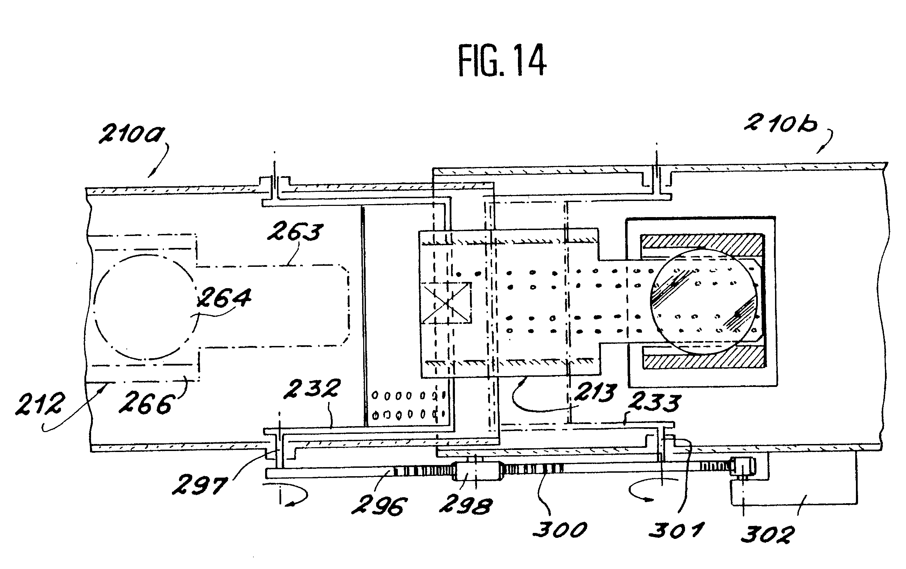

On voit encore sur les figures 13 et 14 que la porte 232 du conteneur 210a est solidaire d'une roue dentée 296 par l'intermédiaire d'un axe 297. La roue dentée 296 engrène sur un pignon 298 qui engrène à son tour sur une roue dentée 300 solidaire de la porte 233 du conteneur 210b par l'intermédiaire d'un axe 301. Les roues 296 et 300 et le pignon 298 se trouvent à l'extérieur des conteneurs 210a et 210b, ainsi que le moteur 302 qui permet de faire pivoter la roue 300 et, par conséquent, le pignon 298 et la roue 296. Les axes 297 et 301 traversent les parois des conteneurs de manière étanche, par exemple grâce à un montage d'étanchéité dynamique ou tout autre système de type connu, qui traverse la paroi du conteneur. Ainsi, le moteur 302 commande l'ouverture simultanée des portes 232 et 233. Il est à remarquer que, dans l'exemple représenté ici, le logement 260 se trouve à la partie inférieure du conteneur 210a, tandis que le logement 262 se trouve à la partie supérieure du conteneur 210b. Les mouvements des deux portes se font donc en sens inverse lorsqu'on les ouvre simultanément ou lorsqu'on les ferme simultanément, mais on ne sortirait pas du cadre de l'invention en utilisant des dispositions différentes.

Une opération de transfert des plaquettes de silicium entre les conteneurs 210a et 210b s'effectue de la manière suivante :

Au départ, le conteneur 210a placé sur le chariot 247 se trouve éloigné de la machine 246 et donc du conteneur 210b. Les portes des deux conteneurs sont en position fermée et le support 212 à l'intérieur du conteneur 210a se trouve dans la position illustrée à la figure 13, c'est-à-dire du côté gauche en regardant cette figure. Les plaquettes, qui se trouvaient initialement dans une armoire de stockage (non représentée), ont été déposées sur les pistes 262 du support 212. Le chariot 247 est approché de la machine 246 jusqu'à ce que le nez 316 du conteneur 210a pénètre à l'intérieur du nez 317 du conteneur 210b.

Dans la présente description, on appelle "nez" du conteneur une partie sensiblement cylindrique de celui-ci située en aval de la porte par rapport au sens d'écoulement du gaz à l'intérieur du conteneur lorsque la porte est en position fermée. Dans l'exemple particulier illustré à la figure 13, la section du nez 316 du conteneur 210a est légèrement inférieure à la section du nez 317 du conteneur 210b. Ainsi, lors de l'accouplement, le nez 316 du conteneur 210a se trouve à l'intérieur du nez 317 du conteneur 210b, un espace étant ménagé entre la face externe du nez 316 et la face interne du nez 317.

Les deux conteneurs sont maintenus quelques instants dans cette position (c'est-à-dire avec les portes fermées) afin de nettoyer et purger l'espace situé entre les deux portes. Ceci est effectué grâce à l'air sous pression introduit dans chacun des conteneurs. Cet air traverse les portes, se retrouve dans l'espace situé entre ces dernières et est évacué par l'interstice se trouvant entre les nez 316 et 317. Lorsque cet espace est suffisamment propre, c'est-à-dire d'une propreté égale à celle régnant à l'intérieur des conteneurs, on actionne le moteur 302, ce qui entraîne l'ouverture des portes par l'intermédiaire de la roue dentée 300, du pignon 298 et de la roue dentée 296. Chaque porte est ainsi amenée dans son logement 260 ou 262.

On excite alors l'électroaimant 270 afin qu'il soulève le support 212 et on déplace le système 252 de gauche à droite en regardant la figure 13. Au cours de ce mouvement, la bande 310 vient recouvrir progressivement la fente 306. Ce mouvement se poursuit jusqu'à ce que la partie des pistes 262 située à l'extérieur du boîtier 266 se trouve à l'intérieur du support 213. Le jet de gaz comprimé servant à sustenter les plaquettes 264 est orienté de sorte que ces plaquettes se déplacent de la gauche vers la droite en regardant la figure 13. Les dimensions et la forme du support 213 sont telles qu'au cours de ce mouvement, les plaquettes viennent au-dessus de rayons prévus sur le support 213 après avoir quitté les pistes 262 du support 212 et se posent sur ces rayons lorsqu'elles ne sont plus maintenues en sustentation par l'air comprimé. Lorsque toutes les plaquettes ont été ainsi transférées, le support 213 peut être manoeuvré à l'intérieur de la machine 246 et les plaquettes amenées au poste de travail.

Pendant l'opération qui va être effectuée sur les plaquettes, le conteneur 210a peut rester dans la position d'accouplement ou être séparé du conteneur 210b, par exemple pour effectuer un autre transfert. Il est bien entendu qu'avant d'effectuer cette séparation, il faut ramener le support 212 à sa position de départ et fermer les portes des deux conteneurs. La procédure est la même que celle qui va être décrite maintenant lorsqu'il s'agit de ramener les plaquettes de la machine 246 à l'intérieur du conteneur 210a.

Avant d'effectuer ce transfert en sens inverse, on ramène les deux conteneurs en position d'accouplement comme illustré à la figure 13 et on purge l'espace compris entre les deux portes avant d'ouvrir ces dernières.

Le dispositif 256 (figure 12) est alors actionné afin de ramener les plaquettes à la position 213b du conteneur 213, puis un ascenseur ramène celui-ci à la position 213a. Le système 252 est mis en route afin de ramener le support 212 à la position de travail, c'est-à-dire une position dans laquelle l'extrémité droite des pistes 262 en regardant la figure 13 se trouve à l'intérieur du support 213. L'air comprimé est alors insufflé à travers la paroi supérieure de chacune de ces pistes, de sorte que les plaquettes sont soulevées au-dessus des rayons du support 213 et déplacées de la droite vers la gauche pour revenir à leur position initiale sur les pistes 262 du support 212. Le dispositif 252 est alors mis en mouvement de la droite vers la gauche jusqu'à ce que le support 212 revienne à sa position de départ 212a. On ferme alors les portes 232 et 233 et le chariot 244 peut être éloigné de la machine 246.

Les figures 15 à 17 illustrent un autre mode de réalisation d'un conteneur selon l'invention dans lequel les portes transparentes sont remplacées par des rideaux d'air.

Sur la figure 15, on retrouve le conteneur 210 présentant, du côté gauche en regardant la figure, l'orifice d'entrée 214 qui lui permet d'être alimenté en air ou en gaz comprimé ultrapropre grâce à la conduite 216. On retrouve également le support 212 sur lequel sont placés les objets à traiter ou à transporter, par exemple les plaquettes de silicium. Il est à noter que, dans cette variante, le support 212 peut être fixe par rapport au conteneur 210. L'air ayant traversé ce dernier en sort par l'orifice de sortie 230 situé à droite en regardant la figure.

Cependant, dans cette variante, les portes sont supprimées tandis que l'orifice de sortie 230 est entouré sur tout son pourtour d'une série de buses 318 disposées de manière à insuffler du gaz ultrapropre dans une direction sensiblement perpendiculaire à la direction du gaz traversant le conteneur depuis l'orifice 214 jusqu'à l'orifice 230. Si le conteneur 210 n'était pas alimenté par le gaz arrivant par la conduite 216, le gaz sortant par les buses 318 formerait un rideau d'air au niveau de l'orifice 230. Lorsque le conteneur 210 est alimenté par la conduite 216, les deux jets de gaz, c'est-à-dire celui provenant de la conduite 216 et celui qui est insufflé par les buses 318, se combinent et constituent un flux qui sort du conteneur 210 par l'orifice 230 comme cela est symbolisé par la flèche 320 représentée en traits interrompus sur la figure.

La vue en coupe de la figure 16 montre de manière plus détaillée comment est constitué le dispositif servant à créer un rideau d'air au niveau de l'orifice 230. On voit que la paroi 322 du conteneur 210 comporte à certains endroits un espace interne 324 qui communique avec la source de gaz ultrapropre. Cet espace 324 peut communiquer avec la conduite 216 ou être mis en communication avec la source par d'autres moyens. Un profilé creux 326 est fixé sur la face interne de la paroi 322 du conteneur 210 tout autour de l'orifice 230.

Ce profilé présente, du côté de la paroi 322, une ou plusieurs ouvertures 328 qui lui permettent d'être mis en communication avec l'espace 324 tandis que, sur le côté opposé, il présente un certain nombre d'ouvertures qui constituent les buses 318.

La figure 17 montre l'accouplement de deux conteneurs construits suivant le mode de réalisation de la figure 15. Le premier conteneur, situé du côté gauche en regardant la figure 17, porte la référence 210a tandis que l'autre, situé du côté droit et représenté partiellement en traits mixtes, porte la référence 210b. La section droite du conteneur 210b est légèrement supérieure à celle du conteneur 210a afin que les deux conteneurs puissent pénétrer l'un dans l'autre. Chacun des deux conteneurs présente à sa périphérie extérieure une bride 330 munie d'un système de positionnement et de centrage 332 qui permet aux deux conteneurs d'être parfaitement orientés l'un par rapport à l'autre pour le transfert des plaquettes. Le conteneur 210a contient un support 212 qui peut être identique à celui qui est illustré à la figure 13 avec les pistes 262 sur lesquelles sont diposées les plaquettes de silicium 264. Quant au conteneur 210b, il contient un support 213 qui peut être identique à celui qui est illustré à la figure 13 et éventuellement être fixe par rapport au conteneur 210b. Les dimensions des conteneurs, la position des brides 330, et la position des supports 212 et 213 à l'intérieur de ces conteneurs sont telles que, lorsque les conteneurs 210a et 210b sont accouplés, les supports 212 et 213 sont dans une position qui permet le transfert des plaquettes de l'un à l'autre suivant la méthode décrite ci-dessus.

Au moment de l'accouplement des conteneurs 210a et 210b de la figure 17, on arrête le soufflage d'air par les buses 318, le balayage du volume commun aux deux conteneurs étant assuré uniquement par l'air en provenance de la source d'air ultrapropre qui pénètre par les orifices d'entrée de chaque conteneur et est extrait par l'espace situé entre les parois des conteneurs lorsque ceux-ci sont en position d'accouplement comme cela est illustré par les flèches 334 sur la figure 17. Les brides 330 et 332 peuvent être réalisées en plusieurs parties ou en une seule et, de toute façon, il y a toujours un passage pour l'air entre les brides 330 et 332 lorsque les conteneurs sont accouplés.

Ainsi, l'installation selon l'invention présente des avantages particulièrement intéressants puisqu'ils permettent d'obtenir une très haute propreté à l'intérieur des conteneurs grâce à la diminution du nombre des éléments se trouvant à l'intérieur de ceux-ci, éléments ou appareils qui peuvent être générateurs de poussières et de particules solides à cause des inévitables frottements qui se produisent. On assure donc une excellente qualité des circuits microélectroniques réalisés dans des installations utilisant ces conteneurs puisque les plaquettes sont en permanence dans une ambiance dont on peut garantir la propreté. De plus, le coût de réalisation est réduit puique le volume qu'il est nécessaire de maintenir à la propreté maximale est faible par rapport au volume de la salle dans laquelle ces opérations sont effectuées.

De plus, en cas de changement du diamètre des plaquettes à traiter, l'adaptation des appareils est facile, puisque, dans l'armoire, on ne change que les alvéoles et le panneau avant. Quant aux conteneurs de transfert, leur construction illustrée à la figure 5 fait qu'ils peuvent s'adapter à toutes sortes de situations puisque le caisson 82 peut être fixé sur n'importe quelle face du caisson 96 et que le conteneur fixe 74 servant de sas pour l'introduction dans une machine de traitement est prévu avec des ouvertures sur chaque face, ce qui lui permet de s'adapter à n'importe quelle machine.

Il faut préciser également que la deuxième réalisation, décrite à l'aide des figures 10 à 17, permet d'atteindre à l'intérieur de l'installation un taux de propreté plus élevé que dans le cas de la première. En effet, si la source extérieure de gaz ultrapropre est une réserve de gaz stocké sous pression, ceci permet d'utiliser des gaz autres que l'air, tels que l'azote. Les gaz ainsi stockés sont d'un taux de propreté plus élevé que celui d'une source d'air issue d'une centrale génératrice.

Enfin, il est bien entendu que l'invention ne se limite pas aux seuls modes de réalisation qui viennent d'être décrits ici, mais qu'on peut envisager des variantes. C'est ainsi que l'homme du métier pourra faire varier en fonction de chaque application particulière la forme exacte des conteneurs, les moyens d'alimentation de ceux-ci, la forme et les dimensions des supports pour les plaquettes, et les moyens de transfert de ces dernières d'un conteneur à l'autre.

## Revendications

1. Installation de stockage et de transfert d'objets (24), en vue de leur traitement, dans une atmosphère de haute propreté, placée dans un local de moyenne propreté, comportant :
   - des moyens de stockage desdits objets (24) ;
   - des moyens de traitement desdits objets (24) ;
   - des moyens de transfert desdits objets (24) entre les moyens de stockage et les moyens de traitement d'un desdits objets (24), constitués d'au moins un conteneur mobile (74) et pouvant s'accoupler aux moyens de stockage et aux moyens de traitement ;

- des moyens de ventilation de tout l'intérieur de l'installation pour soumettre en permanence lesdits objets à un flux de gaz de haute propreté ;

caractérisée en ce que :

- lesdits moyens de stockage sont constitués d'une armoire (10) comprenant :

  . au moins un filtre (28) ayant une face amont (30) et une face aval (32) ;

  . des emplacements pour lesdits objets (24) près de la face aval (32) du filtre (28), le flux gazeux traversant le filtre (28) de la face amont (30) à la face aval (32) de celui-ci ;

  . un premier caisson rigide (54) dans lequel se trouvent des emplacements desdits objets (24) ; et

  . au moins un deuxième caisson rigide (56) dans lequel sont placés des moyens de mise en circulation du gaz se trouvant à l'intérieur de l'armoire (10), les deux caissons étant reliés l'un à l'autre par au moins un élément creux et souple (58, 60) apte à absorber les vibrations.

2. Installation selon la revendication 1, caractérisée en ce que l'intérieur de l'installation est maintenu en surpression par rapport au local pour obtenir une étanchéité dynamique.

3. Installation selon la revendication 1 ou 2, caractérisée en ce que, lesdits objets ayant des surfaces planes, lesdits moyens de ventilation sont tels que ledit flux est laminaire et parallèle aux surfaces planes des objets.

4. Installation selon la revendication 1, caractérisée en ce que l'armoire (10) comporte au moins une ouverture pour le passage dudit objet (24) entre l'intérieur et l'extérieur de l'armoire, cette ouverture pouvant être obturée par une porte (68) mobile entre une position de fermeture laissant un passage pour le gaz de l'intérieur du conteneur vers l'extérieur.

5. Installation selon la revendication 4, caractérisée en ce que ladite porte (68) est montée sur l'armoire (10) au moyen d'une tôle fine déformable (150) fixée d'une part à l'armoire (10) et d'autre part à ladite porte (68).

6. Installation selon la revendication 4, caractérisée en ce que l'armoire (10) comporte en outre des moyens de maintien de la porte (68) en position de fermeture.

7. Installation selon la revendication 6, caractérisée en ce que lesdits moyens de maintien de la porte en position de fermeture comprennent :

  - un premier aimant (152) fixé sur la porte (68) ; et

  - un deuxième aimant (154) fixé sur l'armoire (10), les deux aimants étant au voisinage l'un de l'autre lorsque la porte (68) est en position de fermeture.

8. Installation selon l'une quelconque des revendications 4 à 7, caractérisée en ce que l'armoire (10) comprend un robot (158) pouvant se déplacer devant le panneau avant (35) pour ouvrir au moyen d'aimants (172) chaque porte (68) de l'armoire (10) munie chacune d'un aimant frontal (156).

9. Installation selon l'une quelconque des revendications précédentes, caractérisée en ce que les moyens de transfert comprennent également au moins un conteneur fixe (74) servant à l'introduction desdits objets (24) dans une machine de traitement (76) et pouvant s'accoupler avec le conteneur mobile (72).

10. Installation selon la revendication 9, caractérisée en ce que le conteneur fixe (74) comporte :

  - au moins un filtre ayant une face amont et une face aval ;

  - un emplacement pour ledit objet (24) près de la face aval du filtre ;

  - des moyens pour faire circuler le gaz contenu à l'intérieur de ce conteneur, le gaz traversant le filtre de la face amont à la face aval de celui-ci ; et

  - en ce que l'une au moins de ses parois comporte une ouverture (78) apte à laisser passer ledit objet (24) et permettant également le passage d'un moyen de préhension (80) en faisant partie de la machine (76).

11. Installation selon l'une quelconque des revendications 9 ou 10, caractérisée en ce que les conteneurs fixe et mobile (72, 74) comportent un nez (104, 105) en forme de parallélépipède creux dont une extrémité communique avec l'intérieur du conteneur (72, 74) et dont l'autre extrémité comporte un orifice permettant le passage dudit objet (24), cet orifice pouvant être fermé par une porte (106, 109).

12. Installation selon la revendication 11, caractérisée en ce que le conteneur mobile (72) a une section droite de son nez parallélépipédique (104), et en ce que le conteneur fixe (74) à une section droite de son nez (105) différente de celle du conteneur mobile (72) afin que l'un des deux puisse pénétrer dans l'autre.

13. Installation selon l'une quelconque des revendications précédentes, caractérisée en ce que le conteneur mobile (72) comprend
    - au moins un filtre (100) ayant une face amont et une face aval ;
    - un emplacement pour ledit objet (24) près de la face aval du filtre (100) ; et
    - des moyens (84, 86) pour faire circuler le gaz contenu à l'intérieur de ce conteneur, le gaz traversant le filtre (100) de la face amont à la face aval de celui-ci.

14. Installation selon la revendication 12, caractérisée en ce que le conteneur mobile (72) comporte en outre des moyens de transfert dudit objet (24) entre l'intérieur et l'extérieur du conteneur (74).

15. Installation selon la revendication 13, caractérisée en ce que lesdits moyens de transfert comprennent :
    - une tige (110) ayant, à l'une de ses extrémités, des moyens de préhension dudit objet (24), cette tige étant déplaçable en translation entre une position rétractée dans laquelle ledit objet (24) est à son emplacement dans le conteneur (74) et une position déployée dans laquelle ledit objet est à l'extérieur du conteneur (74) ; et
    - des moyens de déplacement en translation de ladite tige.

16. Installation selon l'une quelconque des revendications 10 et 13, caractérisée en ce que les conteneurs (72, 74) comportent en outre des moyens pour créer une surpression à l'intérieur de ces conteneurs.

17. Installation selon la revendication 16, caractérisée en ce que lesdits moyens pour créer une surpression comprennent au moins un ventilateur (50, 102) placé de manière à insuffler un gaz à l'intérieur des conteneurs à travers un orifice prévu dans une paroi de ces conteneurs.

18. Installation selon l'une quelconque des revendications 10 ou 13, caractérisée en ce que les moyens pour faire circuler le gaz contenu à l'intérieur de l'installation comprennent au moins des ventilateurs (36, 84) comportant :
    - un arbre (40, 88) mobile en rotation autour de son axe ;
    - au moins un ensemble de pales (42) monté sur cet arbre (40, 88) ; et
    - des moyens (44, 46, 102) de mise en rotation et/ou de maintien de cet arbre (40, 88).

19. Installation selon la revendication 18, caractérisée en ce que les moyens de mise en rotation et/ou de maintien de l'arbre (40, 88) se trouvent à l'extérieur de l'installation, et en ce que l'arbre (40, 88) traverse au moins une paroi de celui-ci à travers un orifice (48) dont la section est supérieure à celle de l'arbre.

20. Installation selon la revendication 18, caractérisée en ce que les ventilateurs comportent en outre au moins un cylindre creux (64), ouvert à ses deux extrémités, à l'intérieur duquel se trouve(nt) le(s)dit(s) ensemble(s) de pales (42).

21. Installation selon l'une quelconque des revendications 10 ou 13, caractérisée en ce que les surfaces intérieures de l'installation sont recouvertes d'une couche mince du matériau constitutif du ou des objet(s) (24) à traiter.

22. Installation selon l'une quelconque des revendications 10 ou 13, caractérisée en ce qu'elle comporte en outre un dispositif de régulation de température et/ou d'hygrométrie.

23. Installation selon la revendication 16, caractérisée en ce que les moyens pour créer une surpression et les moyens pour faire circuler le gaz, sont constitués :
    - d'un orifice d'entrée (214) permettant de mettre l'intérieur de l'installation en communication avec une source extérieure de gaz ultrapropre sous pression ;
    - d'un emplacement dans les conteneurs (210a, 210b) pour ledit objet situé de telle sorte que cet objet soit balayé par le gaz circulant à l'intérieur des conteneurs (210, 210a, 210b).

24. Installation selon la revendication 23, caractérisée en ce que les conteneurs (210, 210a, 210b) comportent en outre un système de nettoyage par un gaz sous pression.

25. Installation selon la revendication 24, caractérisée en ce que le système de nettoyage comprend au moins une buse (234) reliée à ladite source de gaz sous pression et des moyens pour insuffler le gaz à travers la buse (234), celle-ci étant disposée de manière à diriger le gaz ultrapropre vers un endroit donné à l'intérieur du conteneur (210, 210a, 210b).

**26.** Installation selon la revendication 23, caractérisée en ce que le conteneur (210, 210a, 210b) comporte en outre :
- une porte (232) comprenant un panneau ayant une face interne et une face externe et présentant des ouvertures de petite dimension ; et
- des moyens (302, 300, 298, 296) pour déplacer cette porte (232) entre une position fermée dans laquelle le panneau obture l'orifice de sortie (230) et une position ouverte dans laquelle cet orifice de sortie (230) n'est pas obturé.

**27.** Installation selon la revendication 26, caractérisée en ce que le conteneur (210, 210a, 210b) comprend en outre :
- un logement (260), séparé du reste du conteneur (210, 210a, 210b), dans lequel se trouve la porte (232) en position ouverte, ce logement (260) communiquant avec le reste du conteneur (210, 210a, 210b) par une première ouverture permettant le passage de la porte (232) et avec le local par une deuxième ouverture ; et
- des moyens (290, 292) pour insuffler le gaz ultrapropre sur la face interne du panneau lorsque la porte (232) se trouve dans ce logement (260).

**28.** Installation selon la revendication 27, caractérisée en ce que le conteneur (210a, 210b) comporte en outre :
- une électrode (294) placée à l'intérieur du logement (260) en regard de la face externe du panneau lorsque la porte (232) est en position ouverte ; et
- des moyens pour appliquer un potentiel électrique à cette électrode (294).

**29.** Installation selon la revendication 23, caractérisée en ce que le conteneur (210, 210a, 210b) comporte en outre une grille (244) placée entre l'orifice d'entrée (214) et l'emplacement dudit objet de sorte que le gaz balayant ledit objet passe à travers cette grille (244).

**30.** Installation selon la revendication 29, caractérisée en ce qu'elle comporte en outre des moyens pour appliquer un potentiel électrique à ladite grille.

**31.** Installation selon la revendication 23, caractérisée en ce que, le ou lesdits objets se trouvant sur un support (212), elle comporte en outre des moyens pour déplacer ce support à l'intérieur du conteneur.

**32.** Installation selon la revendication 31, caractérisée en ce que lesdits moyens de déplacement comprennent :
- un carter (268) placé au-dessus d'une partie du conteneur et séparé de celle-ci par une paroi (304) ;
- au moins un orifice mettant ce carter en communication avec le local ;
- un système (252) de préhension et de levage dudit support (212) logé dans le carter (268) et relié à ce support (212) par un élément de liaison (272) qui passe à travers une fente (306) ménagée dans ladite paroi (304) ;
- des moyens pour déplacer le système de préhension et de levage (252) à l'intérieur dudit carter (268) entre une position de repos et une position de travail, l'élément de liaison (272) restant dans ladite fente (306) au cours de ce mouvement ; et
- une bande de masquage (310) ayant une première extrémité fixée à un enrouleur (312) et une deuxième extrémité fixée au système de préhension et de levage (252), cette bande (310) recouvrant progressivement ladite fente (306) en restant à faible distance de ladite paroi (304) au fur et à mesure que le système de préhension et de levage (252) passe de la position de repos à la position de travail.

**33.** Installation selon la revendication 23, caractérisée en ce que le conteneur (210, 210a, 210b) comporte en outre des moyens pour créer un rideau de gaz ultrapropre au niveau de l'orifice de sortie (230).

**34.** Installation selon l'une des revendications 1, 10 ou 13, caractérisée en ce que le (ou les) filtre(s) est (ou sont) un (ou des) filtre(s) absolu(s).

**35.** Installation selon la revendication 10, caractérisée en ce que le conteneur fixe (74) comprend une porte (109).

**36.** Installation selon la revendication 13, caractérisée en ce que le conteneur mobile (72) comprend une porte (106).

**37.** Installation selon la revendication 13 ou 36, caractérisée en ce que le conteneur mobile (72) contient un premier caisson rigide (96) et un second caisson rigide (82), ces deux caissons étant reliés entre eux par un élément creux et souple (90).

**Claims**

1. Installation for the storage and transfer of objects, with a view to the treatment thereof, into an ultra-clean atmosphere, located in a room having an average cleanness, comprising means for storing the said objects (24), means for treatment of the said objects (24), means for transferring the said objects (24) between the storage means and the treatment means for one of the objects (24), constituted by at least one mobile container (74) and which can be coupled to the storage means and to the treatment means, means for ventilating the entire interior of the installation in order to permanently expose the said objects to a flow of ultra-clean gas, characterized in that the said storage means are constituted by a cabinet (10) incorporating at least one filter (28) having an upstream face (30) and a downstream face (32), locations for the said objects (24) close to the downstream face (32) of the filter (28), the gas flow passing through the filter (28) from the upstream face (30) to the downstream face (32) thereof, a first rigid case (54) in which are located the locations of the said objects (24) and at least one second rigid case (56) in which are placed the means for circulating the gas located within the cubicle (10), the two cases being interconnected by at least one hollow, flexible element (58,60) able to absorb vibrations.

2. Installation according to claim 1, characterized in that the interior of the installation is maintained under an overpressure with respect to the room in order to obtain dynamic sealing.

3. Installation according to claims 1 or 2, characterized in that said objects having planar surfaces, the ventilation means are such that the flow is laminar and parallel to the planar surfaces of the objects.

4. Installation according to claim 1, characterized in that the cubicle (10) has at least one opening for the passage of the said object (24) between the interior and the exterior of the cubicle, said opening being closable by a door (68) moving between a closure position leaving a passage for the gas from the interior to the exterior of the container.

5. Installation according to claim 4, characterized in that the said door (68) is mounted on the cubicle (10) by means of a fine, deformable metal sheet (150) fixed on the one hand to the cubicle (10) and on the other to the said door (68).

6. Installation according to claim 4, characterized in that the cubicle (10) also has means for keeping the door (68) in the closed position.

7. Installation according to claim 6, characterized in that the means for keeping the door in the closed position comprise a first magnet (152) fixed to the door (68) and a second magnet (154) fixed to the cubicle (10), the two magnets being in the vicinity of one another when the door (68) is in the closed position.

8. Installation according to any one of the claims 4 to 7, characterized in that the cabinet (10) has a robot (158) able to move infront of the front panel (34) to open bymeans of magnets (172) each door (68) of the cabinet (10), each provided with a front magnet (156).

9. Installation according to any one of the preceding claims, characterized in that the transfer means also comprise at least one fixed container (74) used for the introduction of the said object (24) into a treatment machine (76) and which can be coupled to the mobile container (72).

10. Installation according to claim 9, characterized in that the fixed container (74) has at least one filter having an upstream face and a downstream face, a location for the said object (24) close to the downstream face of the filter, means for making the gas contained within said container flow, the gas traversing the filter from the upstream face to the downstream face thereof and in that at least one of its walls has an opening (78) permitting the passage of the said object (24) and also permitting the passage of a gripping means (80) forming part of the machine (76).

11. Installation according to either of the claims 9 and 10, characterized in that the fixed and mobile containers (72,74) have a nose (104,105) in the form of a hollow parallelepiped, whereof one end communicates with the interior of the container (72,74) and whereof the other end has an orifice permitting the passage of the said object (24), whereby said orifice can be closed by a door (106,109).

12. Installation according to claim 11, characterized in that the mobile container (72) has a parallelepipedic cross-section of its nose (104) and in that the fixed container (74) has a cross-section of its nose (105) differing from that of the mobile container (72), in order that the two can penetrate one another.

**13.** Installation according to any one of the preceding claims, characterized in that the mobile container (72) comprises at least one filter (100) having an upstream face and a downstream face, a location for the said object (24) close to the downstream face of the filter (100) and means (84,86) for making the gas contained within the container flow, the gas traversing the filter (100) from the upstream face to the downstream face thereof.

**14.** Installation according to claim 12, characterized in that the mobile container (72) also has means for transferring the said object (24) between the interior and the exterior of the container (74).

**15.** Installation according to claim 13, characterized in that the said transfer means incorporate a rod (110) having, at one of its ends, means for gripping the said object (24), said rod being displaceable in translation between a retracted position in which the said object (24) is in its location in the container (74) and an extended position in which the said object is outside the container (74) and means for the displacement in translation of the said rod.

**16.** Installation according to either of the claims 10 and 13, characterized in that the container (72,74) also have means for creating an overpressure within said containers.

**17.** Installation according to claim 16, characterized in that the means for producing an overpressure have at least one fan (50,102) positioned in such a way as to blow air into the containers through an orifice in one wall of the said container.

**18.** Installation according to either of the claims 10 and 13, characterized in that the means for making the gas within the installation flow comprise at least fans (36,84) having a shaft (40,88) mobile in rotation about its axis, at least one group of blades (42) mounted on the said shaft (40,88) and means (44,46,102) for rotating and/or maintaining in position the said shaft (40,88).

**19.** Installation according to claim 18, characterized in that the means for rotating and/or maintaining in position the said shaft (40,88) are located outside the installation and in that the shaft (40,88) traverses at least one wall thereof through an orifice (48) whose cross-section exceeds that of the shaft.

**20.** Installation according to claim 18, characterized in that the fans also have at least one hollow cylinder (64), which is open at its two ends and in the interior of which are located the said assembly or assemblies of blades (42).

**21.** Installation according to either of the claims 10 and 13, characterized in that the inner surfaces of the installation are covered by a thin layer of the constituent material of the object or objects (24) to be treated.

**22.** Installation according to either of the claims 10 and 13, characterized in that it also has a device for regulating the temperature and/or relative humidity.

**23.** Installation according to claim 16, characterized in that the means for producing an overpressure and the means for making the gas flow are constituted by an intake (214) making it possible to link the interior of the installation with an external, pressurized, ultra-clean gas source and a location in the containers (210a,210b) for the said object positioned in such a way that the object is swept by the gas flowing within the containers (210,210a,210b).

**24.** Installation according to claim 23, characterized in that the containers (210,210a,210b) also have a pressurized gas cleaning system.

**25.** Installation according to claim 24, characterized in that the cleaning system comprises at least one nozzle (234) connected to said pressurized gas source and means for blowing the gas through the nozzle (234), the latter being positioned in such a way as to direct the ultra-clean gas towards a given location within the container (210,210a,210b).

**26.** Installation according to claim 23, characterized in that the container (210b) also comprises a door (232) incorporating a panel having an innerface and an outer face, as well as small openings, as well as means (302,300,298,296) for moving the said door (232) between a closed position in which the panel blocks the outlet (230) and an open position in which the outlet (230) is not blocked.

**27.** Installation according to claim 26, characterized in that the container (210,210a,210b) also comprises a recess (260), seperated from the remainder of the container (210,210a,210b), in which the door (232) is located in the open position, said recess (260) being linked with the remainder of the container (210,210a,210b) by a first opening permitting the passage of the door (232) and with the room by a second opening and means (290,292) for blowing in ultra-clean air onto the inner face of the panel when the door (232) is located in the said recess (260).

28. Installation according to claim 27, characterized in that the container (210a,210b) also has an electrode (294) located within the recess (260) and facing the outer face of the panel when the door (232) is in the open position and means for applying an electrical potential to the said electrode (294).

29. Installation according to claim 23, characterized in that the container (210,210a,210b) also has a grid (244) located between the inlet (214) and the location of the said object in such a way that the gas sweeping said object passes through said grid (244).

30. Installation according to claim 29, characterized in that it also has means for applying an electrical potential to the said grid.

31. Installation according to claim 23, characterized in that, with the object or objects being located on a support (212), it also has means for moving the said support within the container.

32. Installation according to claim 31, characterized in that the said displacement means comprise a cover (268) positioned above a part of the container and seperated therefrom by a wall (304), at least one orifice linking said cover with the room, a system (252) for gripping and lifting the said support (212) located in the cover (268) and connected to said support (212) by a connecting member (272), which passes through a slot (306) in said wall (304), means for moving the gripping and lifting system (252) within the said cover (268) between an inoperative position and an operative position, the connecting member (272) remaining in said slot (306) during said movement and a masking tape (310) having a first end fixed to a reel (312) and a second end fixed to the gripping and lifting system (252), said tape (310) progressively covering the said slot, whilst remaining at a short distance from the said wall (304) as the gripping and lifting system (252) passes from the inoperative into the operative position.

33. Installation according to claim 23, characterized in that the container (210,210a,210b) also has means for producing an ultra-clean gas curtain level with the outlet (230).

34. Installation according to one of the claims 1,10 or 13, characterized in that the filters or filters are absolute filters.

35. Installation according to claim 10, characterized in that the fixed container (74) comprises a door (109).

36. Installation according to claim 13, characterized in that the mobile container (72) comprises a door (106).

37. Installation according to claims 13 or 36, characterized in that the mobile container (72) contains a first rigid case (96) and a second rigid case (82), said two cases being interconnected by a hollow, flexible element (90).

**Patentansprüche**

1. Einrichtung zum Lagern und zum Transport von Gegenständen (24) zur ihrer Bearbeitung in einer hochreinen Atmosphäre, die in einem Raum mittlerer Reinheit angeordnet ist, mit:
   - Speichervorrichtungen für die Gegenstände (24);
   - Bearbeitungsvorrichtungen für die Gegenstände (24);
   - Transportvorrichtungen für die Gegenstände (24) zwischen den Speichervorrichtungen und den Bearbeitungsvorrichtungen für die Gegenstände (24), die aus wenigstens einem beweglichen Behälter (74) bestehen und sich mit den Speichervorrichtungen und den Bearbeitungsvorrichtungen verbinden können;
   - Ventilationsvorrichtungen für das gesamte Innere der Einrichtung, um die Gegenstände permanent einem Gasfluß hoher Reinheit zu unterwerfen;
   dadurch gekennzeichnet, daß:
   - die Speichervorrichtungen aus einem Schrank (10) bestehen, der umfaßt:
     . wenigstens einen Filter (28) mit einer Oberseite (30) und einer Unterseite (32);
     . Plätze für die Gegenstände (24) nahe der Unterseite des Filters (28), wobei der Gasfluß den Filter (28) von der Oberseite (30) zur Unterseite (32) desselben durchquert;
     . einen ersten, festen Kasten (54), in dem sich die Plätze für die Gegen-

stände (24) befinden; und

. wenigstens einen zweiten, festen Kasten (56), in dem die Vorrichtungen zum Zirkulieren des Gases im Innern des Schrankes (10) angeordnet sind, wobei die beiden Kästen miteinander über wenigstens ein hohles und elastisches Element (58, 60) verbunden sind, das geeignet ist, die Vibrationen zu absorbieren.

2. Einrichtung nach Anspruch 1, dadurch gekennzeichnet, daß das Innere der Einrichtung auf einem Überdruck bezüglich des Raumes gehalten wird, um eine dynamische Dichtheit zu erhalten.

3. Einrichtung nach Anspruch 1 oder 2, dadurch gekennzeichnet, daß, während die Gegenstände ebene Oberflächen besitzen, die Ventilationsvorrichtungen derart sind, daß der Fluß laminar und parallel zu den ebenen Oberflächen der Gegenstände ist.

4. Einrichtung nach Anspruch 1, dadurch gekennzeichnet, daß der Schrank (10) wenigstens eine Öffnung für dem Durchlaß des Gegenstandes (24) zwischen dem Inneren und Äußeren des Schrankes besitzt, wobei diese Öffnung durch eine Tür (68), die zwischen einer Verschlußposition, die einen Durchlaß für das Gas aus dem Inneren des Behälters ins Äußere läßt, beweglich ist, verschlossen wird.

5. Einrichtung nach Anspruch 4, dadurch gekennzeichnet, daß die Tür (68) an dem Schrank (10) mittels eines feinen, verformbaren Bleches (150) montiert ist, das auf der einen Seite am Schrank (10) und auf der anderen Seite an der Tür (68) befestigt ist.

6. Einrichtung nach Anspruch 4, dadurch gekennzeichnet, daß der Schrank (10) außerdem Vorrichtungen zum Festhalten der Tür (68) in Verschlußstellung umfaßt.

7. Vorrichtung nach Anspruch 6, dadurch gekennzeichnet, daß die Vorrichtungen zum Festhalten der Tür in Verschlußstellung umfassen:
   - einen ersten, an der Tür (68) befestigten Magneten (152); und
   - einen zweiten, am Schrank (10) befestigten Magneten (154), wobei die beiden Magneten einander benachbart sind, wenn die Tür (68) in Verschlußstellung ist.

8. Einrichtung nach einem der Ansprüche 4 bis 7, dadurch gekennzeichnet, daß der Schrank (10) einen Manipulator (158) umfaßt, der sich vor der vorderen Platte (35) bewegt, um mittels Magneten (172) jede Tür (68) des Schrankes (10), die jeweils mit einem vorderen Magneten versehen ist, zu öffnen.

9. Einrichtung nach einem der vorhergehenden Ansprüche, dadurch gekennzeichnet, daß die Transportvorrichtungen ebenfalls wenigsten einen festen Behälter (74) umfassen, der zum Einführen der Gegenstände (24) in eine Bearbeitungsmaschine (76) dient und sich mit dem beweglichen Behälter (72) verbinden kann.

10. Einrichtung nach Anspruch 9, dadurch gekennzeichnet, daß der feste Behälter (74) aufweist:
    - wenigstens einen Filter mit einer Oberseite und einer Unterseite;
    - einen Platz für den Gegenstand (24) in der Nähe der Unterseite des Filters;
    - Vorrichtungen zum Zirkulieren des Gases in Inneren dieses Behälters, wobei das Gas den Filter von der Oberseite zu Unterseite desselben durchquert; und
    - dadurch daß wenigstens eine seiner Wände eine Öffnung (78) aufweist, die geeignet ist, den Gegenstand (24) durchzulassen und ebenfalls den Durchgang einer Greifvorrichtung (80) zu ermöglichen, wodurch er Teil der Maschine (76) ist.

11. Einrichtung nach einem der Ansprüche 9 oder 10, dadurch gekennzeichnet, daß die festen und beweglichen Behälter (72, 74) eine Nase (104, 105) in der Form eines hohlen Parallelepipeds aufweisen, von dem ein Ende mit dem Inneren des Behälters (72, 74) in Verbindung steht und von dem das anderen Ende eine Öffnung ausweist, die den Durchgang des Gegenstands ermöglicht, wobei diese Öffnung durch eine Tür (106, 109) verschlossen werden kann.

12. Einrichtung nach Anspruch 11, dadurch gekennzeichnet, daß der bewegliche Behälter (72) einen geraden Bereich seiner Nase (104) in der Form eines Parallelepipeds besitzt und daß der feste Behälter (74) einen geraden Bereich seiner Nase (105) besitzt, der von dem des beweglichen Behälters (72) verschieden ist, damit der eine in den anderen eindringen kann.

13. Einrichtung nach einem der vorhergehenden Ansprüche, dadurch gekennzeichnet, daß der bewegliche Behälter (72) umfaßt:

- wenigstens einen Filter (100) mit einer Oberseite und einer Unterseite;
- einen Platz für den Gegenstand (24) in der Nähe der Unterseite des Filters (100);
- Vorrichtungen (84, 86) zum Zirkulieren des Gases in Inneren dieses Behälters, wobei das Gas den Filter (100) von der Oberseite zu Unterseite desselben durchquert.

14. Einrichtung nach Anspruch 12, dadurch gekennzeichnet, daß der bewegliche Behälter (72) Vorrichtungen zum Transport des Gegenstands (24) zwischen dem Inneren und Äußeren des Behälters (74) umfaßt.

15. Einrichtung nach Anspruch 13, dadurch gekennzeichnet, daß die Transportvorrichtungen umfassen:
- einen Schaft (110), der an einem seiner Enden Greifvorrichtungen für den Gegenstand (24) besitzt, wobei dieser Schaft in Translationsrichtung zwischen einer zurückgezogenen Stellung, in der sich der Gegenstand (24) auf seinem Platz in dem Behälter (74) befindet, und einer ausgefahrenen Stellung, in der der Gegenstand sich außerhalb des Behälters (74) befindet, beweglich ist; und
- Vorrichtungen zum Bewegen des Schafts in Translationsrichtung.

16. Einrichtung nach einem der Ansprüche 10 und 13, dadurch gekennzeichnet, daß die Behälter (72, 74) außerdem Vorrichtungen zum Erzeugen eines Überdrucks im Innern dieser Behälter umfassen.

17. Einrichtung nach Anspruch 16, dadurch gekennzeichnet, daß die Vorrichtung zum Erzeugen eines Überdrucks wenigstens einen Ventilator (50, 102) umfassen, der so angeordnet ist, daß er ein Gas durch eine in einer Wand dieser Behälter vorgesehene Öffnung ins Innere der Behälter bläst.

18. Einrichtung nach einem der Ansprüche 10 oder 13, dadurch gekennzeichnet, daß die Vorrichtungen zum Zirkulieren des Gases im Innern der Einrichtung wenigstens Ventilatoren (36, 84) aufweisen, die umfassen:
- eine bewegliche, sich um ihre Achse drehende Welle (40, 88);
- wenigstens eine Anordnung von auf dieser Welle (40, 88) montierten Flügeln (42); und
- Vorrichtungen (44, 46, 102) zum Inbewegungsetzen und/oder zum Halten dieser Welle (40, 88).

19. Einrichtung nach Anspruch 18, dadurch gekennzeichnet, daß die Vorrichtungen zum Inbewegungsetzen und/oder Halten der Welle (40, 88) sich außerhalb der Einrichtung befinden und daß die Welle (40, 88) wenigstens eine Wand derselben durch eine Öffnung (48) durchquert, deren Querschnitt größer ist als der der Welle.

20. Einrichtung nach Anspruch 18, dadurch gekennzeichnet, daß die Ventilatoren außerdem einen Hohlzylinder (64) umfassen, der an seinen beiden Enden offen ist und in dessen Inneren sich die Anordnung(en) von Flügeln (42) befinden.

21. Einrichtung nach einem der Ansprüche 10 oder 13, dadurch gekennzeichnet, daß die inneren Oberflächen der Einrichtung mit einer dünnen Schicht eines Materials bedeckt sind, aus dem der oder die zu bearbeitenden Gegenstände bestehen.

22. Einrichtung nach einem der Ansprüche 10 oder 13, dadurch gekennzeichnet, daß sie außerdem eine Vorrichtung zur Regulierung von Temperatur und/oder Hygrometrie aufweist.

23. Einrichtung nach einem der Ansprüche 10 oder 13, dadurch gekennzeichnet, daß die Vorrichtungen zum Erzeugen eines Überdrucks und die Vorrichtungen zum Zirkulieren des Gases bestehen aus:
- einer Eingangsöffnung (214), die ermöglicht, das Innere der Einrichtung in Verbindung mit einer externen Quelle von unter Druck stehendem, hochreinem Gas zu bringen;
- einem Platz für die Behälter (210a, 210b) für den Gegenstand, der so angeordnet ist, daß der Gegenstand durch das im Inneren des Behälters (210, 210a, 210b) zirkulierende Gas überstrichen wird.

24. Einrichtung nach Anspruch 23, dadurch gekennzeichnet, daß die Behälter (210, 210a, 210b) außerdem ein System zur Reinigung durch ein unter Druck stehendes Gas aufweisen.

25. Einrichtung nach Anspruch 14, dadurch gekennzeichnet, daß das Reinigungssystem wenigstens eine Düse (234), die mit der Quelle für unter Druck stehendes Gas verbunden ist, und Vorrichtungen aufweist, um das Gas durch die Düse (234) zu blasen, wobei diese so angeordnet ist, daß das hochreine Gas auf eine gegebene Stelle im Innern des Behälters (210, 210a, 210b) gerichtet wird.

26. Einrichtung nach Anspruch 23, dadurch gekennzeichnet, daß der Behälter (210, 210a, 210b) außerdem aufweist:
    - eine Tür (232), die eine Platte mit einer äußeren Seite und einer inneren Seite umfaßt und Öffnungen kleiner Dimension besitzt; und
    - Vorrichtungen (302, 300, 298, 296), um diese Tür (232) zwischen einer geschlossenen Stellung, in der die Platte die Ausgangsöffnung (230) verschließt, und einer geöffneten Stellung, in der diese Ausgangsöffnung (230) nicht verschlossen ist, zu bewegen.

27. Einrichtung nach Anspruch 26, dadurch gekennzeichnet, daß der Behälter (210, 210a, 210b) außerdem aufweist:
    - eine von dem Rest des Behälters (210, 210a, 210b) getrennte Lagerung (260), in der sich die Tür (232) in geöffneter Stellung befindet, wobei diese Lagerung (260) mit dem Rest des Behälters (210, 210a, 210b) über eine erste Öffnung, die den Durchgang der Tür (232) ermöglicht, und mit dem Raum über eine zweite Öffnung in Verbindung steht; und
    - Vorrichtungen (290, 292), um das hochreine Gas auf die innere Fläche der Platte zu blasen, wenn sich die Tür (232) in dieser Lagerung (260) befindet.

28. Einrichtung nach Anspruch 27, dadurch gekennzeichnet, daß der Behälter (210, 210a, 210b) außerdem aufweist:
    - eine im Inneren der Lagerung (260) gegenüber der äußeren Fläche der Platte angeordnete Elektrode (294), wenn sich die Tür (232) in geöffneter Stellung befindet; und
    - Vorrichtungen, um ein elektrisches Potential an diese Elektrode (294) anzulegen.

29. Einrichtung nach Anspruch 23, dadurch gekennzeichnet, daß der Behälter (210, 210a, 210b) außerdem ein Gitter (244) aufweist, das zwischen der Eingangsöffnung (214) und dem Platz für den Gegenstand so angeordnet ist, daß das über den Gegenstand streichende Gas durch dieses Gitter (244) geht.

30. Einrichtung nach Anspruch 29, dadurch gekennzeichnet, daß sie außerdem Vorrichtungen zum Anlegen eines elektrischen Potentials an das Gitter besitzt.

31. Einrichtung nach Anspruch 23, dadurch gekennzeichnet, daß sie, während sich die Gegenstände auf einem Träger (212) befinden, außerdem Vorrichtungen zum Bewegen dieses Trägers in das Innere des Behälters aufweist.

32. Einrichtung nach Anspruch 31, dadurch gekennzeichnet, daß die Bewegungsvorrichtungen umfassen:
    - einen Kasten (268), der oberhalb des einen Teils des Behälters angeordnet ist und von diesem durch eine Wand (304) getrennt ist;
    - wenigstens eine Öffnung, die den Kasten mit dem Raum in Verbindung bringt;
    - ein Greif- und Hebesystem (252) für den Träger (212), das in dem Kasten (268) angeordnet ist und mit diesem Träger (212) über ein Verbindungselement (272) verbunden ist, das durch einen in die Wand (304) geformten Spalt (306) geht;
    - Vorrichtungen, um das Greif- und Hebesystem (252) im Inneren des Kastens (268) zwischen einer Ruhestellung und einer Arbeitsstellung zu bewegen, wobei das Verbindungselement (272) während dieser Bewegung in dem Spalt (306) bleibt; und
    - ein Überdeckungsband (310), von dem ein Ende an einem Aufwickler (312) und ein zweites Ende mit dem Greif- und Hebesystem (252) verbunden ist, wobei dieses Band (310) fortschreitend in dem Maße den Spalt (306) bedeckt, wobei es in einem geringen Abstand von der Wand (304) bleibt, in dem das Greif- und Hebesystem (252) von der Ruhestellung in die Arbeitsstellung geht.

33. Einrichtung nach Anspruch 23, dadurch gekennzeichnet, daß der Behälter (210, 210a, 210b) außerdem Vorrichtungen zum Erzeugen eines Vorhangs aus hochreinem Gas in der Höhe der Ausgangsöffnung (230) besitzt.

34. Einrichtung nach einem der Ansprüche 1, 10 oder 13, dadurch gekennzeichnet, daß der (oder die) Filter ein absoluter (oder absolute) Filter ist (oder sind).

35. Einrichtung nach Anspruch 10, dadurch gekennzeichnet, daß der feste Behälter (74) eine Tür (109) aufweist.

36. Einrichtung nach Anspruch 13, dadurch gekennzeichnet, daß der bewegliche Behälter (72) eine Tür aufweist (106).

37. Einrichtung nach Anspruch 13 oder 36, dadurch gekennzeichnet, daß der bewegliche Behälter (72) einen ersten, steifen Kasten (96) und einen zweiten, steifen Kasten (82) aufweist, wobei diese beiden Kästen untereinander über ein hohles und elastisches Element (90) verbunden sind.

FIG. 1

EP 0 273 791 B1

# FIG. 2

FIG. 3

FIG. 5

FIG. 4

EP 0 273 791 B1

FIG. 6

FIG. 7

EP 0 273 791 B1

FIG 9

FIG. 8

FIG. 10

FIG. 11

FIG. 12

FIG. 13

314 308 268 276 278 280 282

312 252 286

310 270 274 284

272 306

264 304

XIV

216 262 297

214 266 296

244

212

290 292 232 233 254 210b

294 260 210a 316 317

262 213

XIV

298 301

300

EP 0 273 791 B1

34

# FIG. 14

FIG. 17

FIG. 15

FIG. 16